# EUROPEAN PATENT SPECIFICATION

(11) **EP 3 091 060 B1**
(45) Date of publication and mention of the grant of the patent: **28.08.2019**
(21) Application number: 16166858.7
(22) Date of filing: 15.05.2012
(51) Int. Cl.: C09K 11/85, C09K 11/61

(54) **APPARATUS COMPRISING A SCINTILLATOR**
VORRICHTUNG ENTHALTEND EINEN SZINTILLATOR
APPAREIL COMPRENTANT UN SCINTILLATEUR

(30) Priority: 22.09.2011 FR 1158467; 28.09.2011 US 201161540326 P; 16.11.2011 WO PCT/IB2011/003028
(43) Date of publication of application: 09.11.2016
(62) Divisional of application: 12722132.3
(73) Proprietor: Saint-Gobain Cristaux et Détecteurs, 92400 Courbevoie (FR)
(72) Inventor: BLAHUTA, Samuel, 25000 BESANCON (FR); OUSPENSKI, Vladimir, 77140 Saint-Pierre-lès-Nemours (FR)
(74) Representative: Zimmermann & Partner Patentanwälte mbB

(56) References cited:
- POTDEVIN A ET AL: "Structural, morphological and scintillation properties of Ce-doped Y3Al5O12 powders and films elaborated by the sol-gel process", MATERIALS CHEMISTRY AND PHYSICS, ELSEVIER SA, SWITZERLAND, TAIWAN, REPUBLIC OF CHINA, vol. 130, no. 1, 3 August 2011 (2011-08-03), pages 500-506, XP028389166, ISSN: 0254-0584, DOI: 10.1016/J.MATCHEMPHYS.2011.07.019 [retrieved on 2011-07-13]
- HE ET AL: "Growth and optical properties of YBa3B9O18:Ce crystals", JOURNAL OF CRYSTAL GROWTH, ELSEVIER, AMSTERDAM, NL, vol. 307, no. 2, 15 September 2007 (2007-09-15), pages 427-431, XP022497992, ISSN: 0022-0248, DOI: 10.1016/J.JCRYSGRO.2007.06.022
- FRIEDRICH S ET AL: "A 36-Pixel Tunnel Junction Soft X-Ray Spectrometer for Scintillator Material Science", IEEE TRANSACTIONS ON APPLIED SUPERCONDUCTIVITY, IEEE SERVICE CENTER, LOS ALAMITOS, CA, US, vol. 17, no. 2, 1 June 2007 (2007-06-01), pages 351-354, XP011188191, ISSN: 1051-8223, DOI: 10.1109/TASC.2007.898725
- FANG ZHU ET AL: "The influence on intrinsic light emission of calcium tungstate and molybdate powders by multivalence Pr codoping", APPLIED PHYSICS A; MATERIALS SCIENCE & PROCESSING, SPRINGER, BERLIN, DE, vol. 101, no. 4, 21 July 2010 (2010-07-21) , pages 689-693, XP019867990, ISSN: 1432-0630, DOI: 10.1007/S00339-010-5950-3
- KAN YANG ET AL: "Effects of Calcium Codoping on Charge Traps in LSO:Ce Crystals", IEEE TRANSACTIONS ON NUCLEAR SCIENCE, IEEE SERVICE CENTER, NEW YORK, NY, US, vol. 56, no. 5, 1 October 2009 (2009-10-01), pages 2960-2965, XP011278007, ISSN: 0018-9499, DOI: DOI:10.1109/TNS.2009.2027018

## Description

### Field of the Disclosure

The present disclosure is directed to scintillation compounds including rare earth elements, processes of forming them, and apparatuses having scintillators with such compounds.

### Related Art

Scintillators can be used for medical imaging and for well logging in the oil and gas industry as well for the environment monitoring, security applications, and for nuclear physics analysis and applications. Scintillators include scintillation compounds that include rare earth elements, wherein the rare earth element can be a dopant or as a principal constituent within the compound. Further improvement of scintillation compounds is desired. HE ET AL: "Growth and optical properties of YBa3B9O18:Ce crystals", JOURNAL OF CRYSTAL GROWTH, ELSEVIER, AMSTERDAM, NL, vol. 307, no. 2, 15 September 2007 (2007-09-15), pages 427-431, XP022497992, relates to YBa₃B₉O₁₈:Ce crystals and optical properties thereof. FRIEDRICH S ET AL: "A 36-Pixel Tunnel Junction Soft X-Ray Spectrometer for Scintillator Material Science", IEEE TRANSACTIONS ON APPLIED SUPERCONDUCTIVITY, IEEE SERVICE CENTER, LOS ALAMITOS, CA, US, vol. 17, no. 2, 1 June 2007 (2007-06-01), pages 351-354, XP011188191 relates to cerium doped scintillators such as Lu₍₁₋ₓ₎YₓAlO₃:Ce.

### Brief Description of the Drawings

Embodiments are illustrated by way of example and are not limited in the accompanying figures.
FIG. 1 includes an illustration of an apparatus including a scintillator having a scintillation compound in accordance with an embodiment.
FIG. 2 includes an absorbance spectrum for a sample that is annealed and another sample that is not annealed.
FIG. 3 includes plots thermoluminescence intensity for a sample that is annealed and another sample that is not annealed.

Skilled artisans appreciate that elements in the figures are illustrated for simplicity and clarity and have not necessarily been drawn to scale. For example, the dimensions of some of the elements in the figures may be exaggerated relative to other elements to help to improve understanding of embodiments of the invention.

### Detailed Description

The following description in combination with the figures is provided to assist in understanding the teachings disclosed herein. The following discussion will focus on specific implementations and embodiments of the teachings. This focus is provided to assist in describing the teachings and should not be interpreted as a limitation on the scope or applicability of the teachings.

Before addressing details of embodiments described below, some terms are defined or clarified. Group numbers corresponding to columns within the Periodic Table of the Elements use the "New Notation" convention as seen in the CRC Handbook of Chemistry and Physics, 81st Edition (2000).

As used in this specification, color space is expressed in terms of L*, a*, and b* coordinates as specified by the Commission Internationale de l'eclairage ("CIE") 1976. The three coordinates represent the lightness of the color (L* = 0 yields black and L* = 100 indicates diffuse white; specular white may be higher), its position between red/magenta and green (a*, negative values indicate green while positive values indicate magenta) and its position between yellow and blue (b*, negative values indicate blue and positive values indicate yellow).

The letter "M," when referring to a particular element within a compound, is intended to mean a metal element. For example, M²⁺ is used to represent a divalent metal. M³⁺ is used to represent a trivalent metal, which in an embodiment, may be a rare earth element, and in another embodiment, may be a trivalent metal other than a rare earth element, such as Al, Ga, Sc, In, or the like.

The term "principal constituent," when referring to a particular element within a compound, is intended to that the element is present as part of the molecular formula for the compound, as opposed to a dopant. A dopant within a compound is typically present at a concentration no greater than 5% atomic. As an example, Ce-doped LaBr₃ (LaBr₃:Ce) includes La and Br are principal constituents, and Ce as a dopant and not a principal constituent.

The term "rare earth" or "rare earth element" is intended to mean Y, La, and the Lanthanides (Ce to Lu) in the Periodic Table of the Elements. In chemical formulas, a rare earth element can be represented by "RE." Rare earth elements are in a trivalent state unless explicitly noted otherwise. Thus, RE (without a valance state designation) and RE³⁺ can be used interchangeably.

As used herein, the terms "comprises," "comprising," "includes," "including, " "has," "having," or any other variation thereof, are intended to cover a non-exclusive inclusion. For example, a process, method, article, or apparatus that comprises a list of features is not necessarily limited only to those features but may include other features not expressly listed or inherent to such process, method, article, or apparatus. Further, unless expressly stated to the contrary, "or" refers to an inclusive-or and not to an exclusive-or. For example, a condition A or B is satisfied by any one of the following: A is true (or present) and B is false (or not present), A is false (or not present) and B is true (or present), and both A and B are true (or present).

The use of "a" or "an" is employed to describe elements and components described herein. This is done merely for convenience and to give a general sense of the scope of the invention. This description should be read to include one or at least one and the singular also includes the plural, or vice versa, unless it is clear that it is meant otherwise.

Unless otherwise defined, all technical and scientific terms used herein have the same meaning as commonly understood by one of ordinary skill in the art to which this invention belongs. The materials, methods, and examples are illustrative only and not intended to be limiting. To the extent not described herein, many details regarding specific materials and processing acts are conventional and may be found in textbooks and other sources within the scintillation and radiation detection arts.

A scintillator can include scintillation compound that includes a rare earth element. The rare earth element may be present in the scintillation compound as a principal constituent or as a dopant. In a particular scintillation compound, a particular rare earth element can be a constituent, and a different rare earth element can be a dopant. For example, Cs₂LiLuCl₆:Ce includes Lu as a principal constituent and Ce as a dopant. When present as a dopant, the rare earth element may present within a scintillation compound at a concentration of at least approximately 1000 ppm atomic or at least approximately 5000 ppm atomic in an embodiment, and in another embodiment, may be no greater than approximately 200,000 ppm atomic or no greater than approximately 100,000 ppm atomic.

The rare earth elements can be in a trivalent state. Some of the rare earth elements may be in a tetravalent state, such as Ce, Pr, and Tb, and other rare earth elements can include a divalent state, such as Nd, Sm, Eu, Dy, Tm, and Yb. Such elements may be useful as part of the scintillation mechanism for the scintillation compound. By having a significant amount of a rare earth element in a divalent or tetravalent state, a step in the scintillation process may be obviated.

Too much of the rare earth element in the divalent or tetravalent state may cause electronic charge imbalance and may potentially cause electron or hole traps or other undesired affects to occur. Visible evidence of the electronic charge imbalance may be observed as a change in the color of the crystal. A scintillation compound that may be substantially clear may become more yellow or orange upon visual inspection. In order to maintain electronic charge balance, another element with a different valance state can be present to help keep the overall charge in the scintillation compound balanced. In theory, all of a principal constituent may be replaced by rare earth element in a divalent, trivalent, or a tetravalent state and another element in a monovalent, divalent, or tetravalent state.

Although not required, such other element may have only one valance state to better allow the rare earth metal element to remain in its desired valence state. For example, The Group 2 elements and Zn are in a divalent state and do not have a monovalent or trivalent state. Unlike the Group 2 elements and Zn, other metal elements have more than one valence state, such as Cu, Ti, Fe, and many of the rare earth elements. While such other metal elements are not excluded, their presence may cause an undesired reduction-oxidation (redox) reaction.

Ce⁴⁺ + Fe²⁺ ↔ Ce³⁺ + Fe³⁺

In the equation above, Ce⁴⁺ may be desired but the redox reaction may lower the concentration of Ce⁴⁺ in the scintillation compound and such lower concentration may be undesired.

Scintillation compounds as described using the concepts herein may have a high light output, lower energy resolution, lower afterglow, better proportionality, shorter decay time or any combination thereof may be achieved, as compared to a corresponding scintillation compound with rare earth element(s) only in a trivalent state and without other elements that are added to affect the electronic charge.

### 1. Replacement of a M³⁺ principal constituent or dopant with RE⁴⁺ and M²⁺

A metal element in a trivalent state (generally noted as M³⁺), which may or may not include a rare earth element in a trivalent state, can be principal constituent or dopant in a scintillation compound and be replaced by a rare earth element in a tetravalent state (RE⁴⁺) and an element in a divalent state (M²⁺), such as a Group 2 element (alkaline earth metals), Zn, or any combination thereof. Lu₃Al₅O₁₂:Ce is a scintillator compound and may have some or all of Lu, Al, or Ce replaced by a combination of RE⁴⁺ and M²⁺. In a non-limiting example, the scintillator compound can be represented by Lu_{(3-x-y)}RE⁴⁺ₓCa_{y}Al₅O₁₂. RE⁴⁺ can represent a single rare earth element or a combination of rare earth elements in the tetravalent state. In a particular example, RE⁴⁺ may be Ce⁴⁺, Pr⁴⁺, Tb⁴⁺, or a combination thereof. Ca may partly or completely replaced by another Group 2 element, such as Mg, Ba, or Sr, or Zn. Part of the Al may have been replaced by a combination of the RE⁴⁺ and Ca in place of or addition to Lu.

In an embodiment, values for x and y may be selected such that RE⁴⁺, M²⁺, or each of both may be at least approximately 10 ppm atomic, at least approximately 11 ppm atomic, at least approximately 20 ppm atomic, at least approximately 50 ppm atomic, at least approximately 60 ppm atomic, at least approximately 110 ppm atomic, at least approximately 150 ppm atomic, or at least approximately 200 ppm atomic of the scintillation compound. In a particular embodiment, RE⁴⁺, M²⁺, or each of both may be at least approximately 20 ppm atomic as the benefit of using the dopant(s) may be significant, and in another particular embodiment, RE⁴⁺, M²⁺, or each of both may be at least approximately 110 ppm atomic in particular compounds that use a higher concentration of an activator. In another embodiment, values for x and y may be selected such that the rare earth element in the tetravalent state, the element in the divalent state, or each of both may be no greater than approximately 5% atomic, no greater than approximately 5000 ppm atomic, no greater than approximately 2000 ppm atomic, no greater than approximately 1500 ppm atomic, no greater than approximately 900 ppm atomic, no greater than approximately 800 ppm atomic, no greater than approximately 700 ppm atomic, no greater than approximately 600 ppm atomic, or no greater than approximately 500 ppm atomic of the scintillation compound. In a particular embodiment, RE⁴⁺, M²⁺, or each of both may be no greater approximately 5000 ppm atomic as a separate phase within the scintillation compound may form, and in another particular embodiment, RE⁴⁺, M²⁺, or each of both may be no greater than approximately 900 ppm atomic due to the segregation coefficient of a particular scintillation compound may make incorporation of higher amounts more difficult. In still another particular embodiment, RE⁴⁺, M²⁺, or each of both may be no greater than approximately 500 ppm atomic in particular compounds do not need a relatively high concentration of an activator.

RE⁴⁺ and M²⁺ may be added in equal atomic amounts; however, equal amounts of RE⁴⁺ and M²⁺ are not required. In a further embodiment, on a relative basis, a ratio of RE⁴⁺:M²⁺ is at least approximately 1:90, at least approximately 1:50, at least approximately 1:20, at least approximately 1:9, at least approximately 1:5, at least approximately 1:3, at least approximately 1:2, or at least approximately 1:1.5, or at least approximately 1:1.1. In a still a further embodiment, on a relative basis, a ratio of RE⁴⁺:M²⁺ is no greater than approximately 90:1, no greater than approximately 50:1, no greater than approximately 20:1, no greater than approximately 9:1, no greater than approximately 5:1, no greater than approximately 3:1, no greater than approximately 2:1, or at least approximately 1.5:1, or no greater than approximately 1.1:1. In a particular embodiment, the ratio of RE⁴⁺:M²⁺ may be in a range of approximately 1:3 to approximately 3:1 to maintain an acceptable charge balance within the scintillation compound. In a more particular embodiment, the ratio of RE⁴⁺:M²⁺ may be in a range of approximately 1:1.5 to approximately 1.5:1 to maintain to provide even better charge balance within the scintillation compound.

Further, in Gd₃Al₅O₁₂:Ce, the Ce doping can be partly or completely replaced by RE⁴⁺ and M²⁺. When RE is Ce, the amount of Ce⁴⁺ may be expressed as a fraction of total cerium content. In an embodiment, Ce⁴⁺ is at least approximately 5%, at least approximately 11%, at least approximately 15%, at least approximately 20%, at least approximately 35%, or at least approximately 30% of the total cerium content (Ce³⁺ and Ce⁴⁺) of within the scintillation compound. In particular embodiment, an improvement in scintillation properties may be detected when Ce⁴⁺ is at least approximately 5% of the total cerium content, and the improvement becomes more significant when the Ce⁴⁺ is at least approximately 30% of the total cerium content. In another embodiment, Ce⁴⁺ is no greater than 100%, no greater than approximately 90%, no greater than approximately 75%, no greater than approximately 50%, no greater than approximately 40%, no greater than approximately 30%, no greater than approximately 25%, no greater than approximately 20%, no greater than approximately 15%, or no greater than approximately 9% of the total cerium content within the scintillation compound. In another particular embodiment, an improvement in scintillation properties may be the highest when Ce⁴⁺ is at least approximately 100% of the total cerium content, and the improvement may be similarly significant when the Ce⁴⁺ is at least approximately 90% of the total cerium content.

In another embodiment, a different divalent metal atom may not be further added, as such a divalent metal atom can be present as a principal constituent. For example, BaLaB₇O₁₃ already has a divalent metal element, namely Ba, present in the scintillation compound. In this embodiment, RE⁴⁺ can be substituted for part of the La. For example, BaLa₍₁₋ₓ₎RE⁴⁺ₓB₇O₁₃ can be an exemplary compound. Thus, because a divalent is already present, additional Ba may not be required.

Clearly, the replacement of M³⁺ with RE⁴⁺ and M²⁺ is not limited to the particular scintillation compounds described above. For example, in a YAG composition may have some of the Y replaced by a combination of RE⁴⁺ and M²⁺ in the form of co-dopants, such as Y₃Al₅O₁₂:Pr⁴⁺,Ca. Later in this specification, other scintillation compounds are described, and, with such other scintillation compounds, a particular or combination of metal elements in a trivalent state may be partly or completely replaced by a rare earth element in a tetravalent state and a metal element in a divalent state.

### 2. Replacement of a M³⁺ principal constituent or dopant with RE²⁺ and M⁴⁺

A rare earth element or another trivalent element can be a principal constituent or dopant in a scintillation compound and be replaced by a rare earth element in a divalent state (RE²⁺) and an element in a tetravalent state (M⁴⁺), such as Zr, Hf, or any combination thereof. BaAl₁₀MgO₁₇ is a scintillation compound and may have some or all of Al replaced by a combination of RE²⁺ and M⁴⁺. In a non-limiting example, the scintillation compound can be represented by BaAl_{(10-x-y)}RE²⁺ₓHf_{y}MgO₁₇. RE²⁺ can represent a single rare earth element or a combination of rare elements in the divalent state. In a particular example, RE²⁺ may be Nd²⁺, Sm²⁺, Eu²⁺, Dy²⁺, Tm²⁺, Yb²⁺, or a combination thereof. Hf may partly or completely replaced by Zr.

In an embodiment, values for x and y may be selected such that RE²⁺, M⁴⁺, or each of both may be at least approximately 10 ppm atomic, at least approximately 11 ppm atomic, at least approximately 20 ppm atomic, at least approximately 50 ppm atomic, at least approximately 110 ppm atomic, at least approximately 150 ppm atomic, or at least approximately 200 ppm atomic of the scintillation compound. In a particular embodiment, RE²⁺, M⁴⁺, or each of both may be at least approximately 20 ppm atomic as the benefit of using the dopant(s) may be significant, and in another particular embodiment, RE²⁺, M⁴⁺, or each of both may be at least approximately 110 ppm atomic in particular compounds that use a higher concentration of an activator. In another embodiment, values for x and y may be selected such that the rare earth element in the tetravalent state, the element in the divalent state, or each of both may be no greater than approximately 5% atomic, no greater than approximately 5000 ppm atomic, no greater than approximately 2000 ppm atomic, no greater than approximately 1500 ppm atomic, no greater than approximately 900 ppm atomic, no greater than approximately 800 ppm atomic, no greater than approximately 700 ppm atomic, no greater than approximately 600 ppm atomic, or no greater than approximately 500 ppm atomic of the scintillation compound. In a particular embodiment, RE²⁺, M⁴⁺, or each of both may be no greater approximately 5000 ppm atomic as a separate phase within the scintillation compound may form, and in another particular embodiment, RE²⁺, M⁴⁺, or each of both may be no greater than approximately 900 ppm atomic due to the segregation coefficient of a particular scintillation compound may make incorporation of higher amounts more difficult. In still another particular embodiment, RE²⁺, M⁴⁺, or each of both may be no greater than approximately 500 ppm atomic in particular compounds do not need a relatively high concentration of an activator.

RE²⁺ and M⁴⁺ may be added in equal atomic amounts; however, equal amounts of RE²⁺ and M⁴⁺ are not required. In a further embodiment, on a relative basis, a ratio of RE²⁺:M⁴⁺ is at least approximately 1:90, at least approximately 1:50, at least approximately 1:20, at least approximately 1:9, at least approximately 1:5, at least approximately 1:3, at least approximately 1:2, or at least approximately 1:1.5, or at least approximately 1:1.1. In a still a further embodiment, on a relative basis, a ratio of RE²⁺:M⁴⁺ is no greater than approximately 90:1, no greater than approximately 50:1, no greater than approximately 20:1, no greater than approximately 9:1, no greater than approximately 5:1, no greater than approximately 3:1, no greater than approximately 2:1, or at least approximately 1.5:1, or no greater than approximately 1.1:1. In a particular embodiment, the ratio of RE²⁺:M⁴⁺ may be in a range of approximately 1:3 to approximately 3:1 to maintain an acceptable charge balance within the scintillation compound. In a more particular embodiment, the ratio of RE²⁺:M⁴⁺ may be in a range of approximately 1:1.5 to approximately 1.5:1 to maintain to provide even better charge balance within the scintillation compound.

Further, BaAl₁₀MgO₁₇:Eu, the Eu doping can be partly or completely replaced by RE²⁺ and M⁴⁺. When RE²⁺ is Eu²⁺, the amount of Eu²⁺ may be expressed as a fraction of total europium content. In an embodiment, Eu²⁺ is at least approximately 5%, at least approximately 11%, at least approximately 15%, at least approximately 20%, at least approximately 35%, or at least approximately 30% of the total europium content (Eu²⁺ and Eu³⁺) of within the scintillation compound. In particular embodiment, an improvement in scintillation properties may be detected when Eu²⁺ is at least approximately 5% of the total europium, content, and the improvement becomes more significant when the RE²⁺ is at least approximately 30% of the total europium content. In another embodiment, Eu²⁺ is no greater than 100%, no greater than approximately 90%, no greater than approximately 75%, no greater than approximately 50%, no greater than approximately 40%, no greater than approximately 30%, no greater than approximately 25%, no greater than approximately 20%, no greater than approximately 15%, or no greater than approximately 9% of the total europium content within the scintillation compound. In another particular embodiment, an improvement in scintillation properties may be the highest when Eu²⁺ is at least approximately 100% of the total europium content, and the improvement may be similarly significant when the Eu²⁺ is at least approximately 90% of the total europium content.

In another embodiment, a different tetravalent metal atom may not be further added, as such a tetravalent metal atom can be present as a principal constituent. For example, CaHfO₃ already has a tetravalent metal element, namely Hf, present in the scintillation compound. In this embodiment, RE²⁺ can be substituted for part of the Ca. For example, Ca₍₁₋ₓ₎RE²⁺ₓHfO₃ can be an exemplary compound. Thus, because a tetravalent is already present, additional Hf may not be required.

Clearly, the replacement of M³⁺ with RE²⁺ and M⁴⁺ is not limited to the particular scintillation compounds described above. For example, GdCl₃ may have some of the Gd replaced by a combination of RE²⁺ and M⁴⁺ in the form of co-dopants, such as GdCl₃:Eu²⁺,Zr. Later in this specification, other scintillation compounds are described, and, with such other scintillation compounds, a particular or combination of metal elements in a trivalent state may be partly or completely replaced by a rare earth element in a divalent state and a metal element in a tetravalent state.

### 3. Replacement of a M²⁺ principal constituent or dopant with RE³⁺ and M¹⁺

A Group 2 element is in a divalent state and can be principal constituents in a scintillation compound. The Group 2 element may be replaced in part with a combination of RE³⁺ and M¹⁺, such as a Group 1 element (alkali metal), Ag, or any combination thereof. BaFI is an example of a scintillator compound. Some of the Ba can be replaced by RE³⁺ and M¹⁺. In a non-limiting example, the scintillator compound can be represented by Ba_{(1-x-y)}RE³⁺ₓK_{y}FI. RE³⁺ can represent a single rare earth element or a combination of rare earth elements in a trivalent state. K may be partly or completely replaced by another Group 1 element or Ag.

In an embodiment, values for x and y may be selected such that RE³⁺, M¹⁺, or each of both may be at least approximately 10 ppm atomic, at least approximately 11 ppm atomic, at least approximately 20 ppm atomic, at least approximately 50 ppm atomic, at least approximately 110 ppm atomic, at least approximately 150 ppm atomic, or at least approximately 200 ppm atomic of the scintillation compound. In a particular embodiment, RE³⁺, M¹⁺, or each of both may be at least approximately 20 ppm atomic as the benefit of using the dopant(s) may be significant, and in another particular embodiment, RE³⁺, M¹⁺, or each of both may be at least approximately 110 ppm atomic in particular compounds that use a higher concentration of an activator. In another embodiment, values for x and y may be selected such that the rare earth element in the tetravalent state, the element in the divalent state, or each of both may be no greater than approximately 5% atomic, no greater than approximately 5000 ppm atomic, no greater than approximately 2000 ppm atomic, no greater than approximately 1500 ppm atomic, no greater than approximately 900 ppm atomic, no greater than approximately 800 ppm atomic, no greater than approximately 700 ppm atomic, no greater than approximately 600 ppm atomic, or no greater than approximately 500 ppm atomic of the scintillation compound. In a particular embodiment, RE³⁺, M¹⁺, or each of both may be no greater approximately 5000 ppm atomic as a separate phase within the scintillation compound may form, and in another particular embodiment, RE³⁺, M¹⁺, or each of both may be no greater than approximately 900 ppm atomic due to the segregation coefficient of a particular scintillation compound may make incorporation of higher amounts more difficult. In still another particular embodiment, RE³⁺, M¹⁺, or each of both may be no greater than approximately 500 ppm atomic in particular compounds do not need a relatively high concentration of an activator.

RE³⁺ and M¹⁺ may be added in equal atomic amounts; however, equal amounts of RE³⁺ and M¹⁺ are not required. In a further embodiment, on a relative basis, a ratio of RE³⁺:M¹⁺ is at least approximately 1:90, at least approximately 1:50, at least approximately 1:20, at least approximately 1:9, at least approximately 1:5, at least approximately 1:3, at least approximately 1:2, or at least approximately 1:1.5, or at least approximately 1:1.1. In a still a further embodiment, on a relative basis, a ratio of RE³⁺:M¹⁺ is no greater than approximately 90:1, no greater than approximately 50:1, no greater than approximately 20:1, no greater than approximately 9:1, no greater than approximately 5:1, no greater than approximately 3:1, no greater than approximately 2:1, or at least approximately 1.5:1, or no greater than approximately 1.1:1. In a particular embodiment, the ratio of RE³⁺:M¹⁺ may be in a range of approximately 1:3 to approximately 3:1 to maintain an acceptable charge balance within the scintillation compound. In a more particular embodiment, the ratio of RE³⁺:M¹⁺ may be in a range of approximately 1:1.5 to approximately 1.5:1 to maintain to provide even better charge balance within the scintillation compound.

Further, in BaFI:Eu²⁺, the Eu²⁺ doping can be partly or completely replaced by RE³⁺ and M¹⁺. When RE³⁺ is Eu³⁺, the amount of Eu³⁺ may be expressed as a fraction of total europium content. In an embodiment, Eu³⁺ is at least approximately 5%, at least approximately 11%, at least approximately 15%, at least approximately 20%, at least approximately 35%, or at least approximately 30% of the total europium content of within the scintillation compound. In particular embodiment, an improvement in scintillation properties may be detected when Eu³⁺ is at least approximately 5% of the total europium content, and the improvement becomes more significant when the Eu³⁺ is at least approximately 30% of the total europium content. In another embodiment, Eu³⁺ is no greater than 100%, no greater than approximately 90%, no greater than approximately 75%, no greater than approximately 50%, no greater than approximately 40%, no greater than approximately 30%, no greater than approximately 25%, no greater than approximately 20%, no greater than approximately 15%, or no greater than approximately 9% of the total europium content within the scintillation compound. In another particular embodiment, an improvement in scintillation properties may be the highest when Eu³⁺ is at least approximately 100% of the total europium content, and the improvement may be similarly significant when the Eu³⁺ is at least approximately 90% of the total europium content.

In another embodiment, a different monovalent metal atom may not be further added, as such a monovalent metal atom can be present as a principal constituent. For example, BaKPO₄ already has a monovalent metal element, namely K, present in the scintillation compound. In this embodiment, RE³⁺ can be substituted for part of the Ba. For example, Ba₍₁₋ₓ₎RE³⁺ₓKPO₄ can be an exemplary compound. Thus, because a monovalent is already present, additional K may not be required.

Clearly, the replacement of M²⁺ with RE³⁺ and M¹⁺ is not limited to the particular scintillation compounds described above. For example, NaSrPO₄ may have some of the Sr replaced by a combination of RE³⁺ and M¹⁺ in the form of co-dopants, such as NaSrPO₄:Eu³⁺,K. Later in this specification, other scintillation compounds are described, and, with such other scintillation compounds, a particular or combination of metal elements in a divalent state may be partly or completely replaced by a rare earth element in a trivalent state and a metal element in a monovalent state.

The RE²⁺, RE³⁺ and RE⁴⁺ content can be measured using X-ray Absorption Near-Edge Spectroscopy (XANES). This measurement can be performed with synchrotron equipment. An X-ray beam goes through the sample and through one or more references containing only RE²⁺, RE³⁺ or RE⁴⁺. The obtained XANES spectra of the sample can be easily fitted with a linear combination of that of the chosen references to confirm the presence of RE²⁺, RE³⁺, RE⁴⁺, or any combination thereof and to measure the relative content of RE²⁺, RE³⁺ and RE⁴⁺. For cerium, CeF₃ or Ce(NO₃)₃ may be used as a Ce³⁺ reference, and CeO₂ may be used as a Ce⁴⁺ reference. Another way to determine the presence of Ce⁴⁺ can include measuring the absorbance (also called the optical density) of a crystal and determining a ratio of the absorbance of the crystal at 357 nm to the absorbance of the crystal at 280 nm, referenced A₃₅₇/A₂₈₀.

### 4. Exemplary Compounds

The concepts as described herein are applicable to a many different scintillation compounds. Many different formulas for scintillation compounds are provided herein. Particular notations are used particular types of elements. For example, RE can be used to represent a single rare earth element or a combination of rare earth elements, and Ln can be used to represent a single rare earth element or a combination of rare earth elements that is different from RE. M can be used to represent a single metal element or a combination of metal elements. In any of the formulas below, M may include one or more rare earth elements; alternatively, in any of the formulas below, M may not include any rare earth element. In formulas where a valance state is provided, a corresponding element may only have that valence state (e.g., M²⁺ may be an alkaline earth element, M⁴⁺ may be Hf or Zr).

The scintillation compound is a metal oxide. The scintillation compound can be a single metal oxide, such as a trivalent metal oxide, or a mixed metal oxide, wherein the metal oxide includes a combination of different metals as principal constituents. For example, the mixed metal oxide can be a divalent metal-tetravalent metal oxide, a rare earth aluminate, or a rare earth-divalent metal aluminum garnet.

Below are non-limiting, exemplary formulas for families of compounds.

M1³⁺_{(2-2x-2y)}RE⁴⁺₂ₓM2²⁺_{2y}O₃ (Formula 15)

wherein:
M1³⁺ is a trivalent metal element, which may or may not include a trivalent rare earth element;
M2²⁺ is a divalent metal element;
RE⁴⁺ is a tetravalent rare earth element;
each of x and y are greater than or equal to 0 and less than or equal to 0.2; and
(x+y) is greater than or equal to 0.0001 and less than 0.2.

M1³⁺_{(2-2x-2y)}RE²⁺₂ₓM2⁴⁺_{2y}O₃ (Formula 16)

wherein:
M1³⁺ is a trivalent metal element, which may or may not include a trivalent rare earth element;
M2⁴⁺ is a tetravalent metal element;
RE²⁺ is a divalent rare earth element;
each of x and y are greater than or equal to 0 and less than or equal to 0.2; and
(x+y) is greater than or equal to 0.0001 and less than 0.2.

M1³⁺_{(8-8x-8y)}RE⁴⁺₈ₓM₂²⁺_{8y}O₁₂ (Formula 17)

wherein:
M1³⁺ is a trivalent metal element, which may or may not include a trivalent rare earth element;
M2²⁺ is a divalent metal element;
RE⁴⁺ is a tetravalent rare earth element;
each of x and y are greater than or equal to 0 and less than or equal to 0.2; and
(x+y) is greater than or equal to 0.0001 and less than 0.2.

M1³⁺_{(8-8x-8y)}RE²⁺₈ₓM2⁴⁺_{8y}O₁₂ (Formula 18)

wherein:
M1³⁺ is a trivalent metal element, which may or may not include a trivalent rare earth element;
M2⁴⁺ is a tetravalent metal element;
RE²⁺ is a divalent rare earth element;
each of x and y are greater than or equal to 0 and less than or equal to 0.2; and
(x+y) is greater than or equal to 0.0001 and less than 0.2.

M1²⁺_{(1-x-y)}RE³⁺ₓM₂¹⁺_{y}M3⁴⁺O₃ (Formula 19)

wherein:
M1²⁺ is a divalent metal element;
M2¹⁺ is a monovalent metal element;
M3⁴⁺ is a tetravalent metal element;
RE³⁺ is a trivalent rare earth element;
each of x and y are greater than or equal to 0 and less than or equal to 0.2; and
(x+y) is greater than or equal to 0.0001 and less than 0.2.

M1²⁺M2³⁺_{(12-12x-12y)}RE⁴⁺₁₂ₐM3²⁺_{12b}O₁₉ (Formula 20)

wherein:
each of M1²⁺ and M3²⁺ is a divalent metal element, wherein M1²⁺ and M3²⁺ may be the same divalent metal element or different divalent metal elements;
M2³⁺ is a trivalent metal element, which may or may not include a trivalent rare earth element;
RE⁴⁺ is a tetravalent rare earth element;
x and y are greater than or equal to 0 and less than or equal to 0.2; and
(x+y) is greater than or equal to 0.0001 and less than 0.2.

M1²⁺M2³⁺_{(12-12x-12y)}RE²⁺₁₂ₐM3⁴⁺_{12b}O₁₉ (Formula 21)

wherein:
M1²⁺ is a divalent metal element;
M2³⁺ is a trivalent metal element, which may or may not include a trivalent rare earth element;
M3⁴⁺ is a tetravalent metal element;
RE²⁺ is a divalent rare earth element;
x and y are greater than or equal to 0 and less than or equal to 0.2; and
(x+y) is greater than or equal to 0.0001 and less than 0.2.

M1²⁺_{(2-2x-2y)}RE1³⁺ₓM2¹⁺_{y}M3³⁺_{(10-10a-10b)}RE2⁴⁺₁₀ₐM4²⁺_{10b}O₁₇ (Formula 22)

wherein:
each of M1²⁺ and M4²⁺ is a divalent metal element;
M2¹⁺ is a monovalent metal element;
M3³⁺ is a trivalent metal element, which may or may not include a trivalent rare earth element;
RE1³⁺ is a trivalent rare earth element;
RE2⁴⁺ is a tetravalent rare earth element;
each of a, b, x, and y are greater than or equal to 0 and less than or equal to 0.2; and
either or both of (x+y) and (a+b) are greater than or equal to 0.0001 and less than 0.2.

M1²⁺_{(2-2x-2y)}RE1³⁺ₓM2¹⁺_{y}M3³⁺_{(10-10a-10b)}RE2²⁺₁₀ₐM4⁴⁺_{10b}O₁₇ (Formula 23)

wherein:
M1²⁺ is a divalent metal element;
M2¹⁺ is a monovalent metal element;
M3³⁺ is a trivalent metal element, which may or may not include a trivalent rare earth element;
M4⁴⁺ is a tetravalent metal element;
RE1³⁺ is a trivalent rare earth element;
RE2²⁺ is a divalent rare earth element;
each of a, b, x, and y are greater than or equal to 0 and less than or equal to 0.2; and
either or both of (x+y) and (a+b) are greater than or equal to 0.0001 and less than 0.2.

In the formulas above, Formulas 15 and 17 are particular well suited for use as scintillation compounds.

Exemplary compounds that can be modified in accordance with the above-referenced formulas include BaAl₁₀MgO₁₇, BaAl₁₂O₁₉, BaHfO₃, CaHfO₃, Gd₂O₃, Gd₍₃₋₃ₓ₎Y₃ₓGa_{(5-5y)}Al_{5y}O₁₂, Gd₃Sc₂Al₃O₁₂, Gd₃Y₃Al₁₀O₂₄, GdAlO₃, La₂O₃, LaAlO₃, Lu₂O₃, Lu₃Al₅O₁₂, Lu₃Al₅O₁₂, LuAlO₃, SrHfO₃, Y₂O₃, YAlO₃, or the like, wherein each of x and y can range from 0 to 1. Each of the foregoing compounds may include a rare earth dopant that is not provided with the chemical formula.

In yet another embodiment, the scintillation compound can be a metal-boron-oxygen compound. The metal-boron-oxygen compound can be a single metal borate or oxyborate or a mixed metal borate or oxyborate, wherein the metal borate or oxyborate includes a combination of metals as principal constituents. In an embodiment, the metal-boron-oxygen compound can be a Group 1-rare earth metal borate, Group 2 metal borate, a Group 2-rare earth metal borate, a Group 2-rare earth metal oxyborate, or a Group 2 metal borooxyhalide.

Below are non-limiting, exemplary formulas for families of compounds.

M1²⁺_{(3-3x-3y)}RE³⁺₃ₓM₂¹⁺_{3y}(BO₃)₃ (Formula 24)

wherein:
M1²⁺ is a divalent metal element;
M2¹⁺ is a monovalent metal element;
RE³⁺ is a trivalent rare earth element;
each of x and y are greater than or equal to 0 and less than or equal to 0.2; and
(x+y) is greater than or equal to 0.0001 and less than 0.2.

M1³⁺_{(1-x-y)}RE⁴⁺ₓM2²⁺_{y}(BO₃)₃ (Formula 25)

wherein:
M1³⁺ is a trivalent metal element, which may or may not include a trivalent rare earth element;
M2²⁺ is a divalent metal element;
RE⁴⁺ is a tetravalent rare earth element;
each of x and y are greater than or equal to 0 and less than or equal to 0.2; and
(x+y) is greater than or equal to 0.0001 and less than 0.2.

M1³⁺_{(1-x-y)}RE²⁺ₓM2⁴⁺_{y}(BO₃)₃ (Formula 26)

wherein:
M1³⁺ is a trivalent metal element, which may or may not include a trivalent rare earth element;
M2⁴⁺ is a tetravalent metal element;
RE²⁺ is a divalent rare earth element;
each of x and y are greater than or equal to 0 and less than or equal to 0.2; and
(x+y) is greater than or equal to 0.0001 and less than 0.2.

M1³⁺_{(1-x-y)}RE⁴⁺ₓM2²⁺_{y}B₃O₆ (Formula 27)

wherein:
M1³⁺ is a trivalent metal element, which may or may not include a trivalent rare earth element;
M2²⁺ is a divalent metal element;
RE⁴⁺ is a tetravalent rare earth element;
each of x and y are greater than or equal to 0 and less than or equal to 0.2; and
(x+y) is greater than or equal to 0.0001 and less than 0.2.

M1³⁺_{(1-x-y)}RE²⁺ₓM₂⁴⁺_{y}B₃O₆ (Formula 28)

wherein:
M1³⁺ is a trivalent metal element, which may or may not include a trivalent rare earth element;
M2⁴⁺ is a tetravalent metal element;
RE²⁺ is a divalent rare earth element;
each of x and y are greater than or equal to 0 and less than or equal to 0.2; and
(x+y) is greater than or equal to 0.0001 and less than 0.2.

M1³⁺_{(4-4x4-y)}RE⁴⁺₄ₓM₂²⁺_{4y}(BO₃)₃ (Formula 29)

wherein:
M1³⁺ is a trivalent metal element, which may or may not include a trivalent rare earth element;
M2²⁺ is a divalent metal element;
RE⁴⁺ is a tetravalent rare earth element;
each of x and y are greater than or equal to 0 and less than or equal to 0.2; and
(x+y) is greater than or equal to 0.0001 and less than 0.2.

M1³⁺_{(4-4x4-y)}RE²⁺₄ₓM₂⁴⁺_{4y}(BO₃)₃ (Formula 30)

wherein:
M1³⁺ is a trivalent metal element, which may or may not include a trivalent rare earth element;
M2⁴⁺ is a tetravalent metal element;
RE²⁺ is a divalent rare earth element;
each of x and y are greater than or equal to 0 and less than or equal to 0.2; and
(x+y) is greater than or equal to 0.0001 and less than 0.2.

M1²⁺_{(2-2x-2y)}RE³⁺₂ₓM₂¹⁺_{2y}B₅O₉X (Formula 31)

wherein:
M1²⁺ is a divalent metal element;
M2¹⁺ is a monovalent metal element;
RE³⁺ is a trivalent rare earth element;
X is a halogen;
each of x and y are greater than or equal to 0 and less than or equal to 0.2; and
(x+y) is greater than or equal to 0.0001 and less than 0.2.

M1²⁺M2³⁺_{(1-x-y)}RE⁴⁺ₓM3²⁺_{y}B₇O₁₃ (Formula 32)

wherein:
each of M1²⁺ and M3²⁺ is a divalent metal element, wherein M1²⁺ and M3²⁺ may be the same divalent metal element or different divalent metal elements;
M2³⁺ is a trivalent metal element, which may or may not include a trivalent rare earth element;
M3²⁺ is a divalent metal element;
RE⁴⁺ is a tetravalent rare earth element;
each of x and y are greater than or equal to 0 and less than or equal to 0.2; and
(x+y) is greater than or equal to 0.0001 and less than 0.2.

M1²⁺M2³⁺_{(1-x-y)}RE²⁺ₓM3⁴⁺_{y}B₇O₁₃ (Formula 33)

wherein:
M1²⁺ is a divalent metal element;
M2³⁺ is a trivalent metal element, which may or may not include a trivalent rare earth element;
M3⁴⁺ is a tetravalent metal element;
RE²⁺ is a divalent rare earth element;
each of x and y are greater than or equal to 0 and less than or equal to 0.2; and
(x+y) is greater than or equal to 0.0001 and less than 0.2.

M1¹⁺₆M2³⁺_{(1-x-y)}RE⁴⁺ₓM3²⁺_{y}(BO₃)₃ (Formula 34)

wherein:
M1¹⁺ is a monovalent metal element;
M2³⁺ is a trivalent metal element, which may or may not include a trivalent rare earth element;
M3²⁺ is a divalent metal element;
RE⁴⁺ is a tetravalent rare earth element;
each of x and y are greater than or equal to 0 and less than or equal to 0.2; and
(x+y) is greater than or equal to 0.0001 and less than 0.2.

M1¹⁺₆M2³⁺_{(1-x-y)}RE²⁺ₓM3⁴⁺_{y}(BO₃)₃ (Formula 35)

wherein:
M1¹⁺ is a monovalent metal element;
M2³⁺ is a trivalent metal element, which may or may not include a trivalent rare earth element;
M3⁴⁺ is a tetravalent metal element;
RE²⁺ is a divalent rare earth element;
each of x and y are greater than or equal to 0 and less than or equal to 0.2; and
(x+y) is greater than or equal to 0.0001 and less than 0.2.

M1²⁺_{(1-x-y)}RE1³⁺ₓM₂¹⁺_{y}M3³⁺_{(1-a-b)}RE2⁴⁺ₐM4²⁺_{b}BO₄ (Formula 36)

wherein:
each of M1²⁺ and M4²⁺ is a divalent metal element, wherein M1²⁺ and M4²⁺ may be the same divalent metal element or different divalent metal elements;
M2¹⁺ is a monovalent metal element;
M3³⁺ is a trivalent metal element, which may or may not include a trivalent rare earth element;
RE1³⁺ is a trivalent rare earth element;
RE2⁴⁺ is a tetravalent rare earth element;
each of a, b, x, and y are greater than or equal to 0 and less than or equal to 0.2; and
either or both of (x+y) and (a+b) are greater than or equal to 0.0001 and less than 0.2.

M1²⁺_{(1-x-y)}RE1³⁺ₓM₂¹⁺_{y}M3³⁺_{(1-a-b)}RE2²⁺ₐM4⁴⁺_{b}BO₄ (Formula 37)

wherein:
M1²⁺ is a divalent metal element;
M2¹⁺ is a monovalent metal element;
M3³⁺ is a trivalent metal element, which may or may not include a trivalent rare earth element;
M4²⁺ is a tetravalent metal element;
RE1³⁺ is a trivalent rare earth element;
RE2²⁺ is a divalent rare earth element;
each of a, b, x, and y are greater than or equal to 0 and less than or equal to 0.2; and
either or both of (x+y) and (a+b) are greater than or equal to 0.0001 and less than 0.2.

M1²⁺_{(1-x-y)}RE1³⁺ₓM₂¹⁺_{y}M3³⁺_{(1-a-b)}RE2⁴⁺ₐM4²⁺_{b}B₅O₁₀ (Formula 38)

wherein:
each of M1²⁺ and M4²⁺ is a divalent metal element, wherein M1²⁺ and M4²⁺ may be the same divalent metal element or different divalent metal elements;
M2¹⁺ is a monovalent metal element;
M3³⁺ is a trivalent metal element, which may or may not include a trivalent rare earth element;
RE1³⁺ is a trivalent rare earth element;
RE2⁴⁺ is a tetravalent rare earth element;
each of a, b, x, and y are greater than or equal to 0 and less than or equal to 0.2; and
either or both of (x+y) and (a+b) are greater than or equal to 0.0001 and less than 0.2.

M1²⁺_{(1-x-y)}RE1³⁺ₓM2¹⁺_{y}M3³⁺_{(1-a-b)}RE2²⁺ₐM4⁴⁺_{b}B₅O₁₀ (Formula 39)

wherein:
M1²⁺ is a divalent metal element;
M2¹⁺ is a monovalent metal element;
M3³⁺ is a trivalent metal element, which may or may not include a trivalent rare earth element;
M4⁴⁺ is a tetravalent metal element;
RE1³⁺ is a trivalent rare earth element;
RE2²⁺ is a divalent rare earth element;
each of a, b, x, and y are greater than or equal to 0 and less than or equal to 0.2; and
either or both of (x+y) and (a+b) are greater than or equal to 0.0001 and less than 0.2.

M1²⁺_{(3-3x-3y)}RE1³⁺₃ₓM2¹⁺_{3y}M3³⁺_{(1-a-b)}RE2⁴⁺ₐM4²⁺_{b}(BO₃)₃ (Formula 40)

wherein:
each of M1²⁺ and M4²⁺ is a divalent metal element, wherein M1²⁺ and M4²⁺ may be the same divalent metal element or different divalent metal elements;
M2¹⁺ is a monovalent metal element;
M3³⁺ is a trivalent metal element, which may or may not include a trivalent rare earth element;
RE1³⁺ is a trivalent rare earth element;
RE2⁴⁺ is a tetravalent rare earth element;
each of a, b, x, and y are greater than or equal to 0 and less than or equal to 0.2; and
either or both of (x+y) and (a+b) are greater than or equal to 0.0001 and less than 0.2.

M1²⁺_{(3-3x-3y})RE1³⁺₃ₓM₂¹⁺_{3y}M3³⁺_{(1-a-b)}RE2²⁺ₐM4⁴⁺_{b}(BO₃)₃ (Formula 41)

wherein:
M1²⁺ is a divalent metal element;
M2¹⁺ is a monovalent metal element;
M3³⁺ is a trivalent metal element, which may or may not include a trivalent rare earth element;
M4⁴⁺ is a tetravalent metal element;
RE1³⁺ is a trivalent rare earth element;
RE2²⁺ is a divalent rare earth element;
each of a, b, x, and y are greater than or equal to 0 and less than or equal to 0.2; and
either or both of (x+y) and (a+b) are greater than or equal to 0.0001 and less than 0.2.

M1²⁺_{(4-4x-4y)}RE1³⁺₄ₓM₂¹⁺_{4y}M₃³⁺_{(1-a-b)}RE2⁴⁺ₐM4²⁺_{b}(BO₃)₃ (Formula 42)

wherein:
each of M1²⁺ and M4²⁺ is a divalent metal element, wherein M1²⁺ and M4²⁺ may be the same divalent metal element or different divalent metal elements;
M2¹⁺ is a monovalent metal element;
M3³⁺ is a trivalent metal element, which may or may not include a trivalent rare earth element;
RE1³⁺ is a trivalent rare earth element;
RE2⁴⁺ is a tetravalent rare earth element;
each of a, b, x, and y are greater than or equal to 0 and less than or equal to 0.2; and
either or both of (x+y) and (a+b) are greater than or equal to 0.0001 and less than 0.2.

M1²⁺_{(4-4x-4y)}RE1³⁺₄ₓM2¹⁺_{4y}M₃³⁺_{(1-a-b)}RE2²⁺ₐM4⁴⁺_{b}(BO₃)₃ (Formula 43)

wherein:
M1²⁺ is a divalent metal element;
M2¹⁺ is a monovalent metal element;
M3³⁺ is a trivalent metal element, which may or may not include a trivalent rare earth element;
M4⁴⁺ is a tetravalent metal element;
RE1³⁺ is a trivalent rare earth element;
RE2²⁺ is a divalent rare earth element;
each of a, b, x, and y are greater than or equal to 0 and less than or equal to 0.2; and
either or both of (x+y) and (a+b) are greater than or equal to 0.0001 and less than 0.2.

In the formulas above, Formulas 25, 29, 34, 40, and 42 are particular well suited for use as scintillation compounds.

Exemplary compounds that can be modified in accordance with the above-referenced formulas include Ba₂B₅O₉Cl, Ba₂Ca(BO₃)₂, Ba₃Gd(BO3)₃, Ca₄YO(BO₃)₃, CaLaB₇O₁₃, CaYBO₄, GdB₃O₆, GdBO₃, LaB₃O₆, LaBO₃, LaMgB₅O₁₀, Li₆Gd(BO₃)₃, Li₆Y(BO₃)₃, LuBO₃, ScBO₃, YAl₃B₄O₁₂, YBO₃, or the like. Each of the foregoing compounds may include a rare earth dopant that is not provided with the chemical formula.

In a further embodiment, the scintillation compound can be a metal-phosphorus-oxygen compound. The metal-phosphorus-oxygen compound can be a metal phosphite or a metal phosphate. The metal metal-phosphorus-oxygen can be a single metal phosphite or phosphate or a mixed metal phosphite or phosphate, wherein the metal phosphite or phosphate includes a combination of metals as principal constituents. In an embodiment, the metal-phosphorous compound can include as a monovalent metal-rare earth metal phosphite, a Group 2-rare earth metal phosphite, a Group 2 metal phosphate, or a Group 2 metal phosphate halide.

Below are non-limiting, exemplary formulas for families of compounds.

M1²⁺_{(1-x-y)}RE³⁺ₓM2¹⁺_{y}P₂O₆ (Formula 44)

wherein:
M1²⁺ is a divalent metal element;
M2¹⁺ is a monovalent metal element;
RE³⁺ is a trivalent rare earth element;
x and y are greater than or equal to 0 and less than or equal to 0.2; and
(x+y) is greater than or equal to 0.0001 and less than 0.2.

M1²⁺_{(2-2x-2y)}RE³⁺₂ₓM2¹⁺_{2y}P₂O₇ (Formula 45)

wherein:
M1²⁺ is a divalent metal element;
M2¹⁺ is a monovalent metal element;
RE³⁺ is a trivalent rare earth element;
x and y are greater than or equal to 0 and less than or equal to 0.2; and
(x+y) is greater than or equal to 0.0001 and less than 0.2.

M1²⁺_{(3-3x-3y)}RE³⁺₃ₓM2¹⁺_{3y}P₄O₁₃ (Formula 46)

wherein:
M1²⁺ is a divalent metal element;
M2¹⁺ is a monovalent metal element;
RE³⁺ is a trivalent rare earth element;
x and y are greater than or equal to 0 and less than or equal to 0.2; and
(x+y) is greater than or equal to 0.0001 and less than 0.2.

M1²⁺_{(3-3x-3y)}RE³⁺₃ₓM2¹⁺_{3y}(PO₄)₂ (Formula 47)

wherein:
M1²⁺ is a divalent metal element;
M2¹⁺ is a monovalent metal element;
RE³⁺ is a trivalent rare earth element;
x and y are greater than or equal to 0 and less than or equal to 0.2; and
(x+y) is greater than or equal to 0.0001 and less than 0.2.

M1²⁺_{(5-5x-5y)}RE³⁺₅ₓM2¹⁺_{5y}(PO₄)₃X (Formula 48)

wherein:
M1²⁺ is a divalent metal element;
M2¹⁺ is a monovalent metal element;
RE³⁺ is a trivalent rare earth element;
X is a halogen;
x and y are greater than or equal to 0 and less than or equal to 0.2; and
(x+y) is greater than or equal to 0.0001 and less than 0.2.

M1²⁺_{(1-x-y)}RE³⁺ₓM2¹⁺_{y}BPO₅ (Formula 49)

wherein:
M1²⁺ is a divalent metal element;
M2¹⁺ is a monovalent metal element;
RE³⁺ is a trivalent rare earth element;
x and y are greater than or equal to 0 and less than or equal to 0.2; and
(x+y) is greater than or equal to 0.0001 and less than 0.2.

M1²⁺_{(3-3x-3y)}RE³⁺₃ₓM2¹⁺_{3y}B(PO₄)₃ (Formula 50)

wherein:
M1²⁺ is a divalent metal element;
M2¹⁺ is a monovalent metal element;
RE³⁺ is a trivalent rare earth element;
x and y are greater than or equal to 0 and less than or equal to 0.2; and
(x+y) is greater than or equal to 0.0001 and less than 0.2.

M1¹⁺M2²⁺_{(1-x-y)}RE³⁺ₓM3¹⁺_{y}PO₄ (Formula 51)

wherein:
each of M1¹⁺ and M3¹⁺ is a monovalent metal element, wherein M1¹⁺ and M3¹⁺ may be the same monovalent metal element or different monovalent metal elements;
M2²⁺ is a divalent metal element;
RE³⁺ is a trivalent rare earth element;
x and y are greater than or equal to 0 and less than or equal to 0.2; and
(x+y) is greater than or equal to 0.0001 and less than 0.2.

RE1³⁺_{(1-x-y)}RE2⁴⁺ₓM²⁺_{y}PO₄ (Formula 52)

wherein:
M²⁺ is a divalent metal element;
RE1³⁺ is a trivalent rare earth element;
RE2⁴⁺ is a tetravalent rare earth element;
x and y are greater than or equal to 0 and less than or equal to 0.2; and
(x+y) is greater than or equal to 0.0001 and less than 0.2.

RE1³⁺_{(1-x-y)}RE2²⁺ₓM⁴⁺_{y}PO₄ (Formula 53)

wherein:
M⁴⁺ is a tetravalent metal element;
RE1³⁺ is a trivalent rare earth element;
RE2²⁺ is a divalent rare earth element;
x and y are greater than or equal to 0 and less than or equal to 0.2; and
(x+y) is greater than or equal to 0.0001 and less than 0.2.

RE1³⁺_{(1-x-y)}RE2⁴⁺ₓM²⁺_{y}P₂O₇ (Formula 54)

wherein:
M²⁺ is a divalent metal element;
RE1³⁺ is a trivalent rare earth element;
RE2⁴⁺ is a tetravalent rare earth element;
x and y are greater than or equal to 0 and less than or equal to 0.2; and
(x+y) is greater than or equal to 0.0001 and less than 0.2.

RE1³⁺_{(1-x-y)}RE2²⁺ₓM⁴⁺_{y}P₂O₇ (Formula 55)

wherein:
M⁴⁺ is a tetravalent metal element;
RE1³⁺ is a trivalent rare earth element;
RE2²⁺ is a divalent rare earth element;
x and y are greater than or equal to 0 and less than or equal to 0.2; and
(x+y) is greater than or equal to 0.0001 and less than 0.2.

RE1³⁺_{(1-x-y)}RE2⁴⁺ₓM²⁺_{y}P₅O₁₄ (Formula 56)

wherein:
M²⁺ is a divalent metal element;
RE1³⁺ is a trivalent rare earth element;
RE2⁴⁺ is a tetravalent rare earth element;
x and y are greater than or equal to 0 and less than or equal to 0.2; and
(x+y) is greater than or equal to 0.0001 and less than 0.2.

RE1³⁺_{(1-x-y)}RE2²⁺ₓM⁴⁺_{y}P₅O₁₄ (Formula 57)

wherein:
M⁴⁺ is a tetravalent metal element;
RE1³⁺ is a trivalent rare earth element;
RE2²⁺ is a divalent rare earth element;
x and y are greater than or equal to 0 and less than or equal to 0.2; and
(x+y) is greater than or equal to 0.0001 and less than 0.2.

M1¹⁺RE1³⁺_{(1-x-y)}RE2⁴⁺ₓM2²⁺_{y}P₂O₇ (Formula 58)

wherein:
M1¹⁺ is a monovalent metal element;
M2²⁺ is a divalent metal element;
RE1³⁺ is a trivalent rare earth element;
RE2⁴⁺ is a tetravalent rare earth element;
x and y are greater than or equal to 0 and less than or equal to 0.2; and
(x+y) is greater than or equal to 0.0001 and less than 0.2.

M1¹⁺RE1³⁺_{(1-x-y)}RE2²⁺ₓM₂⁴⁺_{y}P₂O₇ (Formula 59)

wherein:
M1¹⁺ is a monovalent metal element;
M2⁴⁺ is a tetravalent metal element;
RE1³⁺ is a trivalent rare earth element;
RE2²⁺ is a divalent rare earth element;
x and y are greater than or equal to 0 and less than or equal to 0.2; and
(x+y) is greater than or equal to 0.0001 and less than 0.2.

M1¹⁺RE1³⁺_{(1-x-y)}RE2⁴⁺ₓM2²⁺_{y}(PO₃)₄ (Formula 60)

wherein:
M1¹⁺ is a monovalent metal element;
M2²⁺ is a divalent metal element;
RE1³⁺ is a trivalent rare earth element;
RE2⁴⁺ is a tetravalent rare earth element;
x and y are greater than or equal to 0 and less than or equal to 0.2; and
(x+y) is greater than or equal to 0.0001 and less than 0.2.

M1¹⁺RE1³⁺_{(1-x-y)}RE2²⁺ₓM₂⁴⁺_{y}(PO₃)₄ (Formula 61)

wherein:
M1¹⁺ is a monovalent metal element;
M2⁴⁺ is a tetravalent metal element;
RE1³⁺ is a trivalent rare earth element;
RE2²⁺ is a divalent rare earth element;
x and y are greater than or equal to 0 and less than or equal to 0.2; and
(x+y) is greater than or equal to 0.0001 and less than 0.2.

M1¹⁺₃RE1³⁺_{(1-x-y)}RE2⁴⁺ₓM2²⁺_{y}(PO₄)₂ (Formula 62)

wherein:
M1¹⁺ is a monovalent metal element;
M2²⁺ is a divalent metal element;
RE1³⁺ is a trivalent rare earth element;
RE2⁴⁺ is a tetravalent rare earth element;
x and y are greater than or equal to 0 and less than or equal to 0.2; and
(x+y) is greater than or equal to 0.0001 and less than 0.2.

M1¹⁺₃RE1³⁺_{(1-x-y)}RE2²⁺ₓM2⁴⁺_{y}(PO₄)₂ (Formula 63)

wherein:
M1¹⁺ is a monovalent metal element;
M2⁴⁺ is a tetravalent metal element;
RE1³⁺ is a trivalent rare earth element;
RE2²⁺ is a divalent rare earth element;
x and y are greater than or equal to 0 and less than or equal to 0.2; and
(x+y) is greater than or equal to 0.0001 and less than 0.2.

Exemplary compounds that can be modified in accordance with the above-referenced formulas include AgGd(PO₃)₄, Ba₂P₂O₇, Ba₃(PO₄)₂, Ba₃B(PO₄)₃, Ba₃P₄O₁₃, Ba₅(PO₄)₃F, BaKPO₄, BaP₂O₆, Ca₅(PO₄)₃F, CaBPO₅, CeP₅O₁₄, CsGd(PO₃)₄, CsLuP₂O₇, CsYP₂O₇, K₃Lu(PO₄)₂, KGd(PO₃)₄, LuP₂O₇, KYP₂O₇, LiCaPO₄, LiGd(PO₃)₄, LuPO₄, NaBaPO₄, NaGd(PO₃)₄, NaLuP₂O₇, RbLuP₂O₇, RbYP₂O₇, Sr₅(PO₄)₃F, or the like. Each of the foregoing compounds may include a rare earth dopant that is not provided with the chemical formula.

In still a further embodiment, the scintillation compound can be a metal-oxygen-sulfur compound. The metal metal-oxygen-sulfur compound can be a single metal oxysulfide or a mixed metal oxysulfide, wherein the metal oxysulfide includes a combination of metals as principal constituents. In an embodiment, the metal-oxygen-sulfur compound can be a metal oxysulfide, such as a rare earth metal oxysulfide.

Below are non-limiting, exemplary formulas for families of compounds.

RE1³⁺_{(2-2x-2y)}RE2⁴⁺₂ₓM²⁺_{2y}O₂S (Formula 64)

wherein:
M²⁺ is a divalent metal element;
RE1³⁺ is a trivalent rare earth element;
RE2⁴⁺ is a tetravalent rare earth element;
x and y are greater than or equal to 0 and less than or equal to 0.2; and
(x+y) is greater than or equal to 0.0001 and less than 0.2.

RE1³⁺_{(2-2x-2y)}RE2²⁺₂ₓM⁴⁺_{2y}O₂S (Formula 65)

wherein:
M⁴⁺ is a tetravalent metal element;
RE1³⁺ is a trivalent rare earth element;
RE2²⁺ is a divalent rare earth element;
x and y are greater than or equal to 0 and less than or equal to 0.2; and
(x+y) is greater than or equal to 0.0001 and less than 0.2.

Exemplary compounds that can be modified in accordance with the above-referenced formulas include Gd₂O₂S, La₂O₂S, or the like. Each of the foregoing compounds may include a rare earth dopant that is not provided with the chemical formula.

In yet a further embodiment, the scintillation compound can be a metal-oxygen-halogen compound. The metal metal-oxygen-halogen compound can be a single metal oxysulfide or a mixed metal oxysulfide, wherein the metal oxysulfide includes a combination of metals as principal constituents. In an embodiment, the metal-oxygen-halogen compound can be a metal oxyhalide, such as a rare earth metal oxyhalide.

Below are non-limiting, exemplary formulas for families of compounds.

RE1³⁺_{(1-x-y)}RE2⁴⁺ₓM²⁺_{y}OX (Formula 66)

wherein:
M²⁺ is a divalent metal element;
RE1³⁺ is a trivalent rare earth element;
RE2⁴⁺ is a tetravalent rare earth element;
X is a halogen;
x and y are greater than or equal to 0 and less than or equal to 0.2; and
(x+y) is greater than or equal to 0.0001 and less than 0.2.

RE1³⁺_{(1-x-y)}RE2²⁺ₓM⁴⁺_{y}OX (Formula 67)

wherein:
M⁴⁺ is a tetravalent metal element;
RE1³⁺ is a trivalent rare earth element;
RE2⁴⁺ is a divalent rare earth element;
X is a halogen;
x and y are greater than or equal to 0 and less than or equal to 0.2; and
(x+y) is greater than or equal to 0.0001 and less than 0.2.

Exemplary compounds that can be modified in accordance with the above-referenced formulas include GdOBr, GdOCl, GdOF, GdOI, LaOBr, LaOCl, LaOF, LaOI, LuOBr, LuOCl, LuOF, LuOI, YOBr, YOCl, YOF, or the like. Each of the foregoing compounds may include a rare earth dopant that is not provided with the chemical formula.

Many scintillation compounds are disclosed herein and are to illustrate, and not limit, scintillation compounds that can be used. After reading this specification, skilled artisans will appreciate that other scintillation compounds may be used, wherein such other scintillation compounds include a rare earth element as a principal constituent or as a dopant.

In the formulas above, each element that is designated by a valance state may be single element or a combination of elements having the same valance state. For example, M¹⁺₃ in a formula may be any one of the Group 1 elements (for example, Li₃, Na₃, K₃, Rb₃, or Cs₃), Ag, or could be a combination of such elements (for example, Cs₂Li, Cs₂Na, Rb₂Li, or the like). M²⁺₂ in a formula may be any one of the Group 2 elements (for example, Be₂, Mg₂, Ca₂, Sr₂, or Ba₂), Zn, or could be any combination of such elements (for example, CaMg, CaSr, SrBa, or the like). A metal in a trivalent state may be a Group 13 element, a rare earth element in the trivalent state, or a combination thereof. For example, a scintillator compound can include or a rare earth aluminum garnet, and M³⁺ may be used for both the rare earth element and Al. A metal in a tetravalent state may be Zr, Hf, or a combination thereof. Similar to the metal elements, X₂ in a formula may represent a single halogen (for example, F₂, Cl₂, Br₂, or I₂) or a combination of halogens (for example, ClBr, BrI, or the like). Thus, except for dopant(s), if any, the scintillation compound can be a substantially single metal compound, a mixed metal compound, or a mixed halogen compound.

The scintillation compound can be in the form of a single crystal or as a polycrystalline material. The scintillation compound in the form of a single crystal may be formed using a fusion zone technique, a Czochralski, a Bridgman, or an edge feed growth (EFG) technique. With the fusion zone technique, a solid material can be processed such that a crystal seed is in contact with one end of the solid, and a heat source causes a local region (portion of the solid) to become molten near the crystal. The temperature of the ambient near the molten material be at a temperature of at least approximately 1600°C or least 1800°C, and may be no greater than approximately 2200°C, or no greater than approximately 2100°C.

As the heat source moves away from the crystal, the molten portion becomes monocrystalline, and a new local region farther from the seed crystal becomes molten. The process is continued until the rest of the solid has become crystallized. The solid can be oriented in a vertical or horizontal direction during the process. The particular crystal growth methods as melting zone and floating zone are belonging to general notation known as fusion zone technique. The fusion zone technique may be able to incorporate a higher level of dopant than the Czochralski or Bridgman growth techniques, as volatilization or segregation of species may limit the ability of how much dopant will be in the crystal. The scintillation compound can be in the form of a polycrystalline material. Such materials can be formed using calcining, pressing, sintering, or any combination thereof. In an embodiment, a polycrystalline powder (obtained by hydrothermal method or by precipitation in alkaline solution or by vapor phase), the powder possibly being compacted with or without the use of a binder or thermally densified or assembled by a sol-gel method. In a further embodiment, the compound can be a monocrystalline or polycrystalline fiber (obtained by micro-pulling down or by EFG), or thin film (obtained by CVD), or a polycrystalline glass-ceramic. The scintillating compound may be incorporated in a host material that may be transparent, such as a glass or a plastic or a liquid or a crystal. The host material may be used to excite indirectly the scintillating compound.

Depending on the composition of the scintillation compound, the scintillation compound may be exposed to a reducing ambient or an oxidizing ambient during formation or during a post-formation anneal. When the scintillation compound includes a rare earth element that is present in a divalent state and a trivalent state, such a compound may be formed using a reducing ambient. In an embodiment, a scintillator compound may include Eu may be in divalent state, Eu²⁺, and a trivalent state, Eu³⁺. When a divalent rare earth element is used, a tetravalent element, such as Zr or Hf, may also be used. Because Zr and Hf do not have or are not readily reduced to a trivalent state, the likelihood of reducing Zr or Hf in the reducing ambient is substantially zero when forming the scintillation compound having a rare earth metal in the divalent state.

The reducing ambient may include a reducing species, an inert gas, or a combination thereof. The reducing species can include H₂, N₂H₄, CH₄, and another suitable reducing species or the like. If CH₄ is used as a reducing species, O₂ may be added so that CO would be formed at the formation temperature. In an embodiment, the reducing ambient includes at least approximately 1.1 vol%, at least approximately 2 vol%, at least approximately 4 vol% of the reducing species, and in another embodiment, the reducing ambient includes no greater than 100 vol%, no greater than approximately 75 vol%, no greater than approximately 50 vol%, no greater than approximately 20 vol%, or no greater than approximately 9 vol% of the reducing species. In terms of absolute pressure, in an embodiment, the reducing ambient comprises at least approximately 1.1 kPa, at least approximately 2 kPa, at least approximately 4 kPa of the reducing species, and in another embodiment, the reducing ambient includes no greater than 101 kPa, no greater than approximately 75 kPa, no greater than approximately 50 kPa, no greater than approximately 20 kPa, or no greater than approximately 9 kPa of the reducing species.

The inert gas can include a noble gas, such as He, Ne, Ar, another noble gas, or any combination thereof. In an embodiment, the reducing ambient includes at least approximately 1.1 vol%, at least approximately 5 vol%, at least approximately 11 vol%, at least approximately 15 vol%, or at least approximately 20 vol% of the inert gas, and in another embodiment, the reducing ambient includes no greater than 100 vol%, no greater than approximately 90 vol%, no greater than approximately 75 vol%, no greater than approximately 50 vol%, or no greater than approximately 40 vol% of the inert gas. The reducing ambient may only include an inert gas, may include substantially no oxygen, or a combination thereof. In a particular embodiment, the inert gas can include at least approximately 50% Ar, and in another particular embodiment, the reducing ambient includes a total reducing species concentration no greater than approximately 5 vol% and a remainder of the reducing ambient comprises Ar. The reducing ambient may include O₂ in a range of approximately 0.0001 vol% to approximately 3% vol%. Such a reducing ambient may have O₂ present to reduce the likelihood of forming defects in the scintillation compound, but not so high as to further oxidize an element that is to be reduced.

The oxidizing ambient can include O₂, O₃, NO, N₂O, CO₂, or any combination thereof. In an embodiment, the oxidizing ambient includes at least approximately 1.4 vol%, at least approximately 5 vol%, at least approximately 11 vol%, at least approximately 15 vol%, or at least approximately 20 vol% of an oxidizing species, and in another embodiment, the oxidizing ambient includes no greater than 100 vol%, no greater than approximately 90 vol%, no greater than approximately 75 vol%, no greater than approximately 50 vol%, no greater than approximately 40 vol%, or no greater than approximately 30 vol% of an oxidizing species. In terms of absolute pressure, in an embodiment, the oxidizing ambient comprises at least approximately 1.4 kPa, at least approximately 5 kPa, at least approximately 11 kPa, at least approximately 15 kPa, or at least approximately 20 kPa of an oxidizing species, and in another embodiment, the oxidizing ambient includes no greater than 101 kPa, no greater than approximately 90 kPa, no greater than approximately 75 kPa, no greater than approximately 50 kPa, or no greater than approximately 40 kPa of an oxidizing species. In a particular embodiment, the oxidation conditions can be achieved by electrical discharge in the material, and in another particular embodiment, annealing may be performed using air alone.

If needed or desired, an anneal may be performed after forming the scintillation compound. The anneal may be performed using any of the ambients previously described. The temperature for the anneal may be at least approximately 1100°C or at least approximately 1200°C, and may be at no greater than approximately 1600°C or no greater than approximately 1500°C.

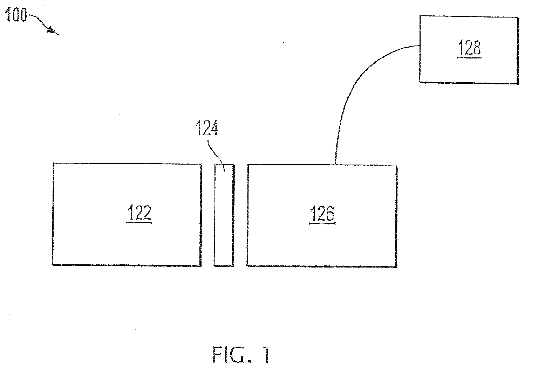

The scintillation compound can be used to form a scintillator or other scintillation device useful in many apparatuses. FIG. 1 illustrates an embodiment of an apparatus 100 that includes a scintillator 122, a light guide 124, a photosensor 126, and control unit 128. The scintillator 122 can include a scintillation compound as previously described. The light guide 124 is substantially transparent to scintillating light emitted by the scintillator 122. The photosensor 126 can generate electrons in response to receiving scintillating light from the scintillator 122. The photosensor 126 can be a photomultiplier, a photodiode, an avalanche diode, or the like. The scintillator 122, the light guide 124, and the photosensor 126 are optically coupled together. Although the scintillator 122, the light guide 124, and the photosensor 126 are illustrated as being spaced apart, the light guide 124 may directly contact the scintillator 122 or the photosensor 126. In another embodiment, a coupling material, such as a substantially clear silicone gel may be used to couple the scintillator 122, the light guide 124, and the photosensor 126 together. The scintillator 122, the light guide 124, and the photosensor 126 may be located inside one or more housings so that ambient light or other undesired radiation does not reach the photosensor 126. The control unit 128 is electrically coupled to the photosensor 126. During normal operation, radiation can be captured by the scintillator 122, and the scintillator 122 emits scintillating light in response to receiving the targeted radiation. The scintillating light is received by the photosensor 126 that generates an electronic signal that is transmitted to the control unit 128. The control unit 128 includes hardware, firmware, or software that is configured so that the control unit 128 can generate information regarding the targeted radiation, such as the type of radiation (x-rays, gamma-rays, beta particles, and the like), intensity of the radiation, location of where the radiation was captured or where the radiation originated, or any combination thereof.

The apparatus can be a radiation detection apparatus, such as a medical imaging apparatus, a well logging apparatus, a security inspection apparatus, or the like. In a particular embodiment, the radiation detection system can be used for gamma ray analysis, such as a Single Positron Emission Computer Tomography (SPECT) or Positron Emission Tomography (PET) analysis. In another embodiment, the scintillation compound may be used for other applications outside of radiation detection. For example, the apparatus can include a luminescence emitter, especially monochromatic, for UV spectra, visible and IR, as for a wavelength conversion system, for example a laser device. In such a device, a control unit can be coupled to the scintillator 122, and the light guide 124 and photosensor 126 can be replaced by a lens or another suitable optical feature. Yet another apparatus that can use the scintillation compound can include an optical data storage device.

Scintillation compounds as described in accordance with the concepts described herein have unusually good light output, energy resolution, linearity, decay time, and afterglow properties. Linearity refers to how well a scintillation crystal approaches perfect linear proportionality between radiation energy and light output. The linearity can be measured as a departure from perfect linearity. A scintillation crystal having perfect linearity would always create the same number of photons per unit energy absorbed, regardless of the energy of the radiation. Thus, its departure from perfect linearity is zero. In an embodiment, a scintillation compound can have an afterglow of less than 200 ppm after 100 ms relative to the intensity measured during an x-ray irradiation. In a particular embodiment, an improvement with less afterglow may be accompanied by a reduction in the decay time and an increase in light yield. The presence of a rare earth element in a divalent or tetravalent state with an electronic charge compensating material can allow a scintillation compound to maintain electronic charge balance, yet still achieve benefits of having the rare earth element in the divalent or tetravalent state.

A non-limiting embodiment is described to illustrate better the current understanding of how concepts described herein are applicable to scintillation compounds. A rare earth aluminum garnet, such as LuAG, can be formed and include at least some rare earth element in the tetravalent state, Ce⁴⁺ within the finished scintillation compound. If too much Ce⁴⁺ is added without any electronic charge compensating species, the LuAG compound may have too many oxygen vacancies that can act as electron traps. When radiation is captured, electrons within the LuAG compound become excited. Some electrons will return to a lower energy state and emit scintillating light, which is desired; however, other electrons become trapped and do not emit light when trapped. The electrons may become untrapped due to temperature and emit light referred to as thermoluminescence. Thus, the electron traps are problematic because electrons that become trapped will not emit scintillating light at the time when electrons outside the traps emitting scintillating light, and electrons released from the traps will emit light but it will be at a time after the scintillating light from non-trapped electrons was emitted. By maintaining better electronic charge balance, oxygen vacancies may be less likely to trap electrons. Continuing with the prior example, a Group 2 element, such as Ca, Mg, Sr, Zn, or the like, can be incorporated into the scintillation compound. The Group 2 element of Zn is in a divalent state and does not or is not readily oxidized. Thus, the LuAG compound can be formed in an oxidizing ambient sufficient to achieve a desired concentration of Ce⁴⁺ without a significant risk of forming oxygen vacancies while still maintaining better electronic charge balance at least in part due to the presence of the Group 2 element or Zn that is not readily oxidized. The addition of a rare earth element in a tetravalent state can obviate a step in the scintillation mechanism in many scintillation compounds. The modified scintillation mechanism consists of the interaction of cerium in 4+ state with high energy X-ray or γ-photons and converting Ce⁴⁺ directly into excited (3+)* state together with generating of a hole. Divalent elements are participating in the scintillation mechanism having a particular role of hole traps.

Ideally, a pair of rare earth metal atoms in a trivalent state is replaced by a rare earth atom in a tetravalent state and a metal atom in a divalent state, such as a Group 2 element, Zn, or any combination thereof. In practice, with respect to replacing rare earth metal atoms in a trivalent state, the ratio of rare earth atoms in a tetravalent state to metal atoms in a divalent state does not need to be 1:1, since not all the dopant atoms are participating in scintillation mechanism and thus, some electronic charge imbalance does not deviate from the concepts are described herein. Better performance may result as the ratio is kept closer to 1:1.

Similar concepts can apply when rare earth elements are reduced. In another non-limiting embodiment, a pair of rare earth metal atoms in a trivalent state is replaced by a rare earth atom in a divalent state and a metal atom in a tetravalent state. A particular compound can include CaLaB₇O₁₃. Some of the La, which is in a trivalent state, may be replaced by Eu²⁺ and Zr, Hf, or a combination thereof. Zr and Hf are in a tetravalent state and are not readily reduced. Thus, the replacement of La with Eu²⁺ and Zr or Hf allows for better electronic charge balance, particularly when the scintillation compound is exposed to a reducing ambient, for example, to keep the Eu³⁺ from being oxidized to Eu³⁺.

In a further non-limiting embodiment, a pair of metal atoms in a divalent state is replaced by a rare earth atom in a trivalent state and a metal atom in a monovalent state, such as a Group 1 element or Ag. A particular compound can include CaI₂. Some of the Ca, which is in a divalent state, may be replaced by Eu²⁺ and Li, Na, or K, or a combination thereof. The Group 1 elements are in a monovalent state and are not readily reduced. Thus, the replacement of Ba with Eu³⁺ and Li, Na, or K allows for better electronic charge balance, particularly when the scintillation compound is exposed to a reducing ambient, for example, to keep the Eu²⁺ from being oxidized to Eu³⁺.

The presence of Ce⁴⁺ can be determined from crystal samples polished on their two parallel sides, through which sides the spectrophotometic operation was carried out. The distance between these parallel sides (thickness of the sample) may be from 0.2 to 50 mm. In a particular embodiment, the samples are nominally 1 mm thick. A Cary 6000i-brand spectrophotometer measuring in the UV and in the visible, marketed by Varian, now part of Agilent Technologies, Inc., under the trade name Cary 6000i, and having a resolution of less than or equal to 1 nm, may be used. The direct transmission mode was used on the samples. Samples were measured using an interval of 0.5 nm, an acquisition time of 0.1 s per point and an SBW (spectral bandwidth) of 2 nm. Absorbance (also called the optical density) of each sample is measured as a function of wavelength between 190 nm and 600 nm. Background noise is subtracted before determining a ratio of the absorbance at 357 nm to the absorbance at 280 nm, referenced A₃₅₇/A₂₈₀.

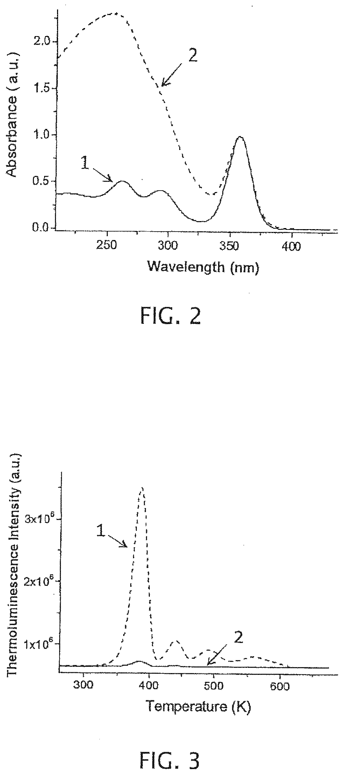

FIG. 2 includes the absorbance spectra in the case of sample 2 (referenced "2" in the figure) after an air annealing (according to an embodiment) and in the case of sample 1 (referenced "1" in the figure), a reference sample, representative of the prior art, that is not annealed. In the case of sample 2, after an air annealing, an absorbance maximum is observed at 250 nm, the origin of which is Ce⁴⁺.

FIG. 3 compares the thermoluminescence intensity of a compound in the case of sample 2 (referenced "2") after an air annealing and in the case of sample 1 (unannealed reference sample, referenced "1") representative of the prior art. In the case of the sample 2, a very substantial drop in the thermoluminescence intensity, especially around 300 K, is noticed, and thus, afterglow is reduced.

References have been published that disclose the addition of dopants to improve the performance of scintillator crystals. US 2011/0204240 teaches that Ca is added so that Ce⁴⁺ forms Ce³⁺ in cerium-doped lutetium yttrium orthosilicate (LYSO:Ce). Clearly, RE⁴⁺ has been undesired in the prior art. Unlike the teachings of the prior art, a rare earth element can be intentionally kept in a divalent or tetravalent state and achieve the benefits of such state while still maintaining electronic charge balance.

In an embodiment, a scintillation compound may be substantially clear. In another embodiment, the color change may be quantified by determining a color difference between a scintillation compound in accordance with any of the embodiments described herein may be compared to its corresponding base compound when both are illuminated by substantially white light. As used herein, a corresponding base compound has a substantially the same composition as the scintillation compound, except that all of its scintillating light activator in a valance state different from a conventional activator for the particular scintillation compound. For example, scintillation compound may have RE³⁺ (e.g., Ce³⁺) as a conventional activator; however a scintillation compound in accordance with an embodiment may have Ce⁴⁺ or a combination of Ce³⁺ and a significant amount of Ce⁴⁺ as a scintillating light activator. The corresponding base compound would have all of the cerium as Ce³⁺ with substantially no or an insignificant amount of Ce⁴⁺. In another example, another scintillation compound may have RE²⁺ (e.g., Eu²⁺) as a conventional activator; however another scintillation compound in accordance with an embodiment may have Eu³⁺ or a combination of Eu²⁺ and Eu³⁺ as a scintillating light activator. The corresponding base compound would have all of the europium as Eu²⁺ with substantially no or an insignificant amount of Eu³⁺.

Samples for color change evaluation may be used as formed, have a surface polished, fractured roughed, or have another suitable sample preparation performed. White light may be directed such that it is directed perpendicular to surface, at an angle other than perpendicular to the surface, or from a plurality of light sources oriented at different angles with respect to the surface. One or more different techniques may be used to determine color change.

In an embodiment, CIE 1976 color space coordinates, L*, a*, and b* can be used. The CIE 1976 color space coordinates may be obtained using a Cary 6000i-brand spectrophotometer from Varian, now part of Agilent Technologies, Inc. The scintillation compound reflects substantially white light at color space coordinates of L1*, a1*, b1* that correspond to CIE 1976 color space coordinates L*, a*, and b* for the scintillation compound. The corresponding base compound reflects substantially white light at color space coordinates of L2*, a2*, b2* that correspond to CIE 1976 color space coordinates L*, a*, and b* for the corresponding base compound. The color difference between the scintillation compound and the base compound may be such that |a1*-a2*| is no greater than approximately 9, and |b1*-b2*| is no greater than approximately 9. In another embodiment, |a1*-a2*| is no greater than approximately 5, is no greater than approximately 3, is no greater than approximately 2, is no greater than approximately 1.5, is no greater than approximately 0.9, is no greater than approximately 0.5, or is no greater than approximately 0.2, is no greater than approximately 0.09, no greater than approximately 0.05, or no greater than approximately 0.01, and |b1*-b2*| is no greater than approximately 5, is no greater than approximately 3, is no greater than approximately 2, is no greater than approximately 1.5, is no greater than approximately 0.9, is no greater than approximately 0.5, or is no greater than approximately 0.2, is no greater than approximately 0.09, no greater than approximately 0.05, or no greater than approximately 0.01. In a further embodiment, |L1*-L2*| is no greater than approximately 9, no greater than approximately 5, is no greater than approximately 3, is no greater than approximately 2, is no greater than approximately 1.5, is no greater than approximately 0.9, is no greater than approximately 0.5, or is no greater than approximately 0.2.

As an alternative to color space coordinates, the wavelength of reflected light may be used. The scintillation compound reflects substantially white light at a first wavelength, and its corresponding base compound reflects substantially white light at a second wavelength. In an embodiment, first and second wavelengths are no greater than approximately 50 nm from each other, no greater than approximately 30 nm, no greater than approximately 20 nm, no greater than approximately 15 nm, no greater than approximately 9 nm, no greater than approximately 5 nm, no greater than approximately 2 nm from each other.

In still another embodiment, a particular spectrum of wavelengths may be used. In one example, a scintillation compound is colorless when sufficiently electronic charge balanced, and a similar scintillator compound has a yellow color if not sufficiently electronic charge balanced. The intensity of the reflected light at wavelengths from 400 nm to 700 nm for the scintillator compounds may be compared. A color change may be determined if the data significantly differ. Alternatively, only blue light (for example, light having an emission maximum at a wavelength in a range of 400 nm to 450 nm) may be used to illuminate the scintillation compounds. The scintillation compound that is colorless may reflect substantially more of the blue light as compared to the scintillation compound that has the yellow color.

In another example, a different scintillation compound has a yellow color when sufficiently electronic charge balanced, and yet another similar scintillator compound has a green color if not sufficiently electronic charge balanced. The intensity of the reflected light at wavelengths from 400 nm to 700 nm for the scintillator compounds may be compared. An analysis may be performed with different color lights. A first set of data may be obtained when, only green light (for example, light having an emission maximum at a wavelength in a range of 500 nm to 550 nm) is used to illuminate the scintillation compounds. A second set of data may be obtained when, only red light (for example, light having an emission maximum at a wavelength in a range of 650 nm to 700 nm) is used to illuminate the scintillation compounds. The scintillation compound that is yellow may reflect substantially more of the red light and less of the green light as compared to the scintillation compound that has the green color.

Many different aspects and embodiments are possible. Some of those aspects and embodiments are described herein. After reading this specification, skilled artisans will appreciate that those aspects and embodiments are only illustrative and do not limit the scope of the present invention. Additionally, those skilled in the art will understand that some embodiments that include analog circuits can be similarly implemented using digital circuits, and vice versa.

### REFERENCE EXAMPLES

The concepts described herein will be further described in the Examples, which do not limit the scope of the invention described in the claims. The Examples demonstrate performance of scintillation crystals of different compositions. Numerical values as disclosed in this Examples section may be approximated or rounded off for convenience.

The examples below help to illustrate potential improvements with light yield (LY) and energy resolution for some exemplary compounds. All sample sizes are in mm, and energy resolution is based on full-width, half-maximum (FWHM) data. Content levels as listed in the tables below are in ppm atomic. Further, in the examples that are doped with Pr, the Pr-doped materials include some Ce as an impurity; however, the amount of Ce is not present in an amount that significantly affects the scintillation properties.

**Example of LaCl₃ doped with cerium:**

| 10x10x10mm cubes | **Ce⁴⁺ Content XANES** | LY (Photons/MeV ¹³⁷Cs 662 keV) | Energy resolution |
|---|---|---|---|
| LaCl₃:Ce | 50 ppm | 48000 | 4.7% |
| LaCl₃:Ce,Ca²⁺ | 1250 ppm | 50500 | 4.5% |
| LaCl₃:Ce,Mg²⁺ | 1000 ppm | 50000 | 4.6% |
| LaCl₃:Ce,Ba²⁺ | 600 ppm | 49000 | 4.5% |
| LaCl₃:Ce,Sr²⁺ | 600 ppm | 49000 | 4.45% |

**Examples with CLYC doped cerium or praseodymium**

| 10x10x10mm cubes | **RE⁴⁺ content XANES** | LY (Photons/MeV ¹³⁷Cs 662 keV) | Energy resolution |
|---|---|---|---|
| Cs₂LiYCl₆Ce | not detectable | 21000 | 6.6% |
| Cs₂LiYCl₆:Ce,Ca²⁺ | 1200 ppm | 21000 | 6.2% |
| Cs₂LiYCl₆:Ce,Mg²⁺ | 800 ppm | 21000 | 6.1% |
| Cs₂LiYCl₆:Ce,Sr²⁺ | 750 ppm | 21000 | 6.2% |
| Cs₂LiYCl₆:Ce,Ba²⁺ | 500 ppm | 21000 | 6.3% |
| Cs₂LiYCl₆:Pr | not detectable | 8500 | 8.4% |
| Cs₂LiYCl₆:Pr,Ca²⁺ | 400 ppm | 9500 | 7.2% |
| Cs₂LiYCl₆:Pr,Mg²⁺ | 350 ppm | 9500 | 6.8% |
| Cs₂LiYCl₆:Pr,Sr²⁺ | 550 ppm | 9500 | 6.7% |
| Cs₂LiYCl₆:Pr:Ce,Ba²⁺ | 600 ppm | 9500 | 6.7% |

**Examples with CLLC doped cerium or praseodymium**

| 10x10x10mm cubes | **RE⁴⁺ content XANES** | LY (Photons/MeV ¹³⁷Cs 662 keV) | Energy resolution |
|---|---|---|---|
| Cs₂LiLaCl₆:Ce | not detectable | 34000 | 3.9% |
| Cs₂LiLaCl₆:Ce,Ca²⁺ | 800 ppm | 34000 | 3.6% |
| Cs₂LiLaCl₆:Ce,Mg²⁺ | 900 ppm | 34000 | 3.6% |
| Cs₂LiLaCl₆:Ce,Ba²⁺ | 600 ppm | 34000 | 3.6% |
| Cs₂LiLaCl₆:Pr | not detectable | 10500 | 8.4% |
| Cs₂LiLaCl₆:Pr,Ca²⁺ | 550 ppm | 10500 | 8.0% |
| Cs₂LiLaCl₆:Pr,Mg²⁺ | 400 ppm | 10500 | 7.8% |
| Cs₂LiLaCl₆:Pr,Ba²⁺ | 500 ppm | 10500 | 7.8% |

**Examples with CLLB doped cerium or praseodymium**

| 10x10x10mm cubes | **RE⁴⁺ Content XANES** | LY (Photons/MeV ¹³⁷Cs 662 keV) | Energy resolution |
|---|---|---|---|
| Cs₂LiLaBr₆:Ce | not detectable | 34500 | 5.1% |
| Cs₂LiLaBr₆:Ce,Ca²⁺ | 800 ppm | 36500 | 4.8% |
| Cs₂LiLaBr₆:Ce,Mg²⁺ | 700 ppm | 36000 | 4.8% |
| Cs₂LiLaBr₆:Ce,Ba²⁺ | | | |
| Cs₂LiLaBr₆:Pr | not detectable | 16000 | 6.7% |
| Cs₂LiLaBr₆:Pr,Mg²⁺ | 400 ppm | 16000 | 6.4% |
| Cs₂LiLaBr₆:Pr,Ba²⁺ | 450 ppm | 16000 | 6.5% |
| Cs₂LiLaBr₆:Pr,Ca²⁺ | 500 ppm | 16000 | 6.4% |

**Examples with SrI₂ doped europium**

| 2x6x6mm | **RE³⁺ Content XANES** | LY (Photons/MeV ¹³⁷Cs 662 keV) | Energy resolution |
|---|---|---|---|
| SrI₂:2%Eu | not detectable | 98000 | 3.1% |
| SrI₂:2%Eu,Cs¹⁺ | 400 ppm | 98000 | 2.9% |

**Examples with CeBr3**

| 2x6x6mm | **RE⁴⁺ Content XANES** | LY (Photons/MeV ¹³⁷Cs 662 keV) | Energy resolution |
|---|---|---|---|
| CeBr₃ | not detectable | 66000 | 3.6% |
| CeBr₃,Ca²⁺ | 800 ppm | 66000 | 3.4% |
| CeBr₃,Mg²⁺ | 700 ppm | 66000 | 3.45% |
| CeBr₃,Sr²⁺ | 900 ppm | 66000 | 3.4% |
| CeBr₃,Ba²⁺ | 650 ppm | 66000 | 3.45% |

**Examples with K₂YF₅ doped praseodymium**

| 2x6x6mm | **RE⁴⁺ Content XANES** | LY (Photons/MeV ¹³⁷Cs 662 keV) | Energy resolution |
|---|---|---|---|
| K₂YF₅:Pr | not detectable | 7000 | 8.6% |
| K₂YF₅:Pr,Ca²⁺ | 400 ppm | 7000 | 8.2% |
| K₂YF₅:Pr,Sr²⁺ | 350 ppm | 7000 | 8.2% |
| K₂YF₅:Pr,Mg²⁺ | 400 ppm | 7000 | 8.0% |
| K₂YF₅:Pr,Ba²⁺ | 250 ppm | 7000 | 8.4% |

**Examples with CeC13 undoped**

| 2x6x6mm | **RE⁴⁺ Content XANES** | LY (Photons/MeV ¹³⁷Cs 662 keV) | Energy resolution |
|---|---|---|---|
| CeCl₃ | not detectable | 46000 | 3.5% |
| CeCl₃,Ca²⁺ | 300 ppm | 46000 | 3.4% |
| CeCl₃,Mg²⁺ | 350 ppm | 46000 | 3.4% |
| CeCl₃,Sr²⁺ | 350 ppm | 46000 | 3.3% |
| CeCl₃,Ba²⁺ | 250 ppm | 46000 | 3.45% |

**Examples with CeF₃ lutetium doped**

| 2x6x6mm | **RE⁴⁺ Content XANES** | LY (Photons/MeV ¹³⁷Cs 662 keV) | Energy resolution |
|---|---|---|---|
| CeF₃:Lu | not detectable | 8500 | 9.2% |
| CeF₃:Lu,Ca²⁺ | 650 ppm | 8500 | 8.8% |
| CeF₃:Lu,Mg²⁺ | 780 ppm | 8500 | 8.7% |
| CeF₃:Lu,Sr²⁺ | 700 ppm | 8500 | 8.8% |
| CeF₃:Lu,Ba²⁺ | 600 ppm | 8500 | 9.0% |

**Examples with PrBr₃ doped cerium**

| 2x6x6mm | **RE⁴⁺ Content XANES** | LY (Photons/MeV ¹³⁷Cs 662 keV) | Energy resolution |
|---|---|---|---|
| PrBr₃:Ce | not detectable | 17500 | 5.5% |
| PrBr₃:Ce,Ca²⁺ | 400 ppm | 17500 | 5.2% |
| PrBr₃:Ce,Mg²⁺ | 450 ppm | 17500 | 5.35% |
| PrBr₃:Ce,Sr²⁺ | 500 ppm | 17500 | 5.3% |
| PrBr₃:Ce,Ba²⁺ | 400 ppm | 17500 | 5.4% |

The Examples demonstrate a significant improvement of energy resolution (that is lower energy resolution) when a combination of RE⁴⁺ and M²⁺ as within the scintillation compound as compared to a scintillation compound without the RE⁴⁺ and M²⁺. In general, the energy resolution is in a range of approximately 5% to 20% lower for the scintillation compounds with RE⁴⁺ and M²⁺ co-dopants, as compared to the same compound without the co-dopants. For the scintillator compound with the RE³⁺ and M¹⁺ co-dopants, the improvement is significant but not as great as for the RE⁴⁺ and M²⁺ co-dopants. Scintillation is more effective with electrons as compared to holes. Still, the scintillation compound with RE³⁺ and M¹⁺ helps to improve performance.

## Claims

1. An apparatus comprising a scintillator including a scintillation compound comprising a rare earth element in a tetravalent state at a concentration of at least 10 ppm atomic of the scintillation compound, wherein the scintillation compound is not a rare earth silicate compound, wherein the scintillation compound is a metal oxide.

2. The apparatus of claim 1, wherein the metal oxide is a mixed metal oxide, wherein the metal oxide includes a combination of different metals as principal constituents.

3. The apparatus of claim 2, wherein the mixed metal oxide is a metal-aluminum-oxygen compound, wherein the metal is different from aluminum.

4. The apparatus of claim 3, wherein the metal-aluminum-oxygen compound comprises a metal aluminate.

5. The apparatus of claim 3, wherein the metal-aluminum-oxygen compound comprises a metal aluminum garnet.

6. The apparatus of claim 1, wherein the scintillation compound has the following formula:
M1³⁺_{(2-2x-2y)}RE⁴⁺₂ₓM2²⁺_{2y}O₃
wherein:
M1³⁺ is a trivalent metal element, which may or may not include a trivalent rare earth element;
M2²⁺ is a divalent metal element;
RE⁴⁺ is a tetravalent rare earth element;
x is greater than 0 and less than or equal to 0.2, y is greater than or equal to 0 and less than or equal to 0.2; and
(x+y) is greater than or equal to 0.0001 and less than 0.2.

7. The apparatus of claim 1, wherein the scintillation compound has the following formula:
M1³⁺_{(8-8x-8y)}RE⁴⁺₈ₓM2²⁺_{8y}O₁₂
wherein:
M1³⁺ is a trivalent metal element, which may or may not include a trivalent rare earth element;
M2²⁺ is a divalent metal element;
RE⁴⁺ is a tetravalent rare earth element;
x is greater than 0 and less than or equal to 0.2, y is greater than or equal to 0 and less than or equal to 0.2; and
(x+y) is greater than or equal to 0.0001 and less than 0.2.

8. The apparatus of claim 1, wherein the scintillation compound has the following formula:
M1²⁺_{(2-2x-2y)} RE1³⁺ₓM2¹⁺_{y}M3²⁺_{(10-10a-10b)}RE2⁴⁺₁₀ₐₓM4²⁺_{10b}O₁₇
wherein:
each of M1²⁺ and M4^{2x} is a divalent metal element;
M2¹⁺ is a monovalent metal element;
M3^{3x} is a trivalent metal element which may or may not include a trivalent rare earth element;
RE1³⁺ is a trivalent rare earth element;
RE2⁴⁺ is a tetravalent rare earth element;
a and x is greater than 0 and less than or equal to 0.2, and each of b and y are greater than or equal to 0 and less than or equal to 0.2; and
either both of (x+y) and (a+b) are greater than or equal to 0.0001 and less than 0.2.

9. An apparatus comprising a scintillator including a scintillation compound comprising a rare earth element in a tetravalent state at a concentration of at least 10 ppm atomic of the scintillation compound, wherein the scintillation compound is not a rare earth silicate compound, wherein the scintillation compound comprises a metal-boron-oxygen compound.

10. The apparatus of any one of the preceding claims, wherein the apparatus is a radiation detection apparatus and further comprises a photosensor configured to receive scintillating light from the scintillator.

11. The apparatus of any one of the preceding claims, wherein the apparatus comprises a medical imaging apparatus, a well logging apparatus, or a security inspection apparatus.

12. The apparatus of any one of the preceding claims, wherein the apparatus is a laser device or an optical data storage device.

13. The apparatus of any one of the preceding claims, wherein the rare earth element in the tetravalent state is at a concentration no greater than 5% atomic of the scintillation compound.

14. The apparatus of any one of the preceding claims, wherein the rare earth element is a particular rare earth element in the tetravalent state, wherein the particular rare earth element in the tetravalent state is at least 5% and no greater than 90% of the total content of the particular rare earth element within the scintillation compound.

## Patentansprüche

1. Vorrichtung mit einem Szintillator, der eine Szintillationsverbindung umfasst, die ein Seltenerdelement in einem vierwertigen Zustand bei einer Konzentration von mindestens 10 Atom-ppm der Szintillationsverbindung umfasst, wobei die Szintillationsverbindung keine Seltenerdsilikatverbindung ist und wobei die Szintillationsverbindung ein Metalloxid ist.

2. Vorrichtung nach Anspruch 1, wobei das Metalloxid ein gemischtes Metalloxid ist, wobei das Metalloxid eine Kombination verschiedener Metalle als Hauptbestandteile enthält.

3. Vorrichtung nach Anspruch 2, wobei das gemischte Metalloxid eine Metall-Aluminium-Sauerstoff-Verbindung ist, wobei sich das Metall von Aluminium unterscheidet.

4. Vorrichtung nach Anspruch 3, wobei die Metall-Aluminium-Sauerstoff-Verbindung ein Metallaluminat umfasst.

5. Vorrichtung nach Anspruch 3, wobei die Metall-Aluminium-Sauerstoff-Verbindung ein Metall-Aluminium-Granat umfasst.

6. Vorrichtung nach Anspruch 1, wobei die Szintillationsverbindung die folgende Formel hat:
M1³⁺_{(2-2x-2y)}RE⁴⁺₂ₓM2²⁺_{2y}O₃
wobei:
M1³⁺ ein dreiwertiges Metallelement ist, das ein dreiwertiges Seltenerdelement enthalten kann oder nicht;
M2²⁺ ein zweiwertiges Metallelement ist;
RE⁴⁺ ein vierwertiges Seltenerdelement ist;
x größer als 0 und kleiner als oder gleich 0,2 ist, y größer als oder gleich 0 und kleiner als oder gleich 0,2 ist; und
(x + y) größer oder gleich 0,0001 und kleiner als 0,2 ist.

7. Vorrichtung nach Anspruch 1, wobei die Szintillationsverbindung die folgende Formel hat:
M1³⁺_{(8-8x-8y)}RE⁴⁺₈ₓM2²⁺_{8y}O₁₂
wobei:
M1³⁺ ein dreiwertiges Metallelement ist, das ein dreiwertiges Seltenerdelement enthalten kann oder nicht;
M2²⁺ ein zweiwertiges Metallelement ist;
RE⁴⁺ ein vierwertiges Seltenerdelement ist;
x größer als 0 und kleiner als oder gleich 0,2 ist, y größer als oder gleich 0 und kleiner als oder gleich 0,2 ist; und
(x + y) größer oder gleich 0,0001 und kleiner als 0,2 ist.

8. Vorrichtung nach Anspruch 1, wobei die Szintillationsverbindung die folgende Formel hat:
M1²⁺_{(2-2x-2y)}RE1³⁺ₓM2¹⁺_{y}M3²⁺_{(10-10a-10b)}RE2⁴⁺₁₀ₐₓM4²⁺_{10b}O₁₇
wobei:
jedes von M1²⁺ und M4^{2x} ein zweiwertiges Metallelement ist;
M2¹⁺ ein einwertiges Metallelement ist;
M3^{3x} ein dreiwertiges Metallelement ist, das ein dreiwertiges Seltenerdelement enthalten kann oder nicht;
RE1³⁺ ein dreiwertiges Seltenerdelement ist;
RE2⁴⁺ ein vierwertiges Seltenerdelement ist;
a und x größer als 0 und kleiner als oder gleich 0,2 sind und b und y jeweils größer als oder gleich 0 und kleiner als oder gleich 0,2 sind; und
beide von (x + y) und (a + b) größer als oder gleich 0,0001 und kleiner als 0,2 sind.

9. Vorrichtung mit einem Szintillator, der eine Szintillationsverbindung umfasst, die ein Seltenerdelement in einem vierwertigen Zustand in einer Konzentration von mindestens 10 Atom-ppm der Szintillationsverbindung umfasst, wobei die Szintillationsverbindung keine Seltenerdsilikatverbindung ist und wobei die Szintillationsverbindung eine Metall-Bor-Sauerstoff-Verbindung umfasst.

10. Vorrichtung nach einem der vorhergehenden Ansprüche, wobei die Vorrichtung eine Strahlungserfassungsvorrichtung ist und ferner einen Photosensor umfasst, der zum Empfangen von Szintillationslicht von dem Szintillator konfiguriert ist.

11. Vorrichtung nach einem der vorhergehenden Ansprüche, wobei die Vorrichtung eine medizinische Bildgebungsvorrichtung, eine Bohrlochmessvorrichtung oder eine Sicherheitsinspektionsvorrichtung umfasst.

12. Vorrichtung nach einem der vorhergehenden Ansprüche, wobei die Vorrichtung eine Laservorrichtung oder eine optische Datenspeichervorrichtung ist.

13. Vorrichtung nach einem der vorhergehenden Ansprüche, wobei das Seltenerdelement im vierwertigen Zustand eine Konzentration von nicht mehr als 5 % Atom der Szintillationsverbindung aufweist.

14. Vorrichtung nach einem der vorhergehenden Ansprüche, wobei das Seltenerdelement ein bestimmtes Seltenerdelement im vierwertigen Zustand ist, wobei das bestimmte Seltenerdelement im vierwertigen Zustand mindestens 5 % und nicht mehr als 90 % des Gesamtgehalts des jeweiligen Seltenerdelements in der Szintillationsverbindung beträgt.

## Revendications

1. Appareil comprenant un scintillateur incluant un composé de scintillation comprenant un métal des terres rares dans un état tétravalent à une concentration atomique d'au moins 10 ppm du composé de scintillation, dans lequel le composé de scintillation n'est pas un composé silicate de terres rares, dans lequel le composé de scintillation est un oxyde métallique.

2. Appareil selon la revendication 1, dans lequel l'oxyde métallique est un oxyde métallique mixte, dans lequel l'oxyde métallique comprend une combinaison de différents métaux en tant que constituants principaux.

3. Appareil selon la revendication 2, dans lequel l'oxyde métallique mixte est un composé métal-aluminium-oxygène, dans lequel le métal est différent de l'aluminium.

4. Appareil selon la revendication 3, dans lequel le composé métal-aluminium-oxygène comprend un aluminate de métal.

5. Appareil selon la revendication 3, dans lequel le composé métal-aluminium-oxygène comprend un grenat de métal et d'aluminium.

6. Appareil selon la revendication 1, dans lequel le composé de scintillation répond à la formule suivante :
M1³⁺_{(2-2x-2y)}RE⁴⁺₂ₓM2²⁺_{2y}O₃
dans laquelle :
M1³⁺ est un élément métallique trivalent, qui peut inclure ou non un métal des terres rares trivalent ;
M2²⁺ est un élément métallique divalent ;
RE⁴⁺ est un métal des terres rares tétravalent ;
x est supérieur à 0 et inférieur ou égal à 0,2, y est supérieur ou égal à 0 et inférieur ou égal à 0,2 ; et
(x+y) est supérieur ou égal à 0,0001 et inférieur à 0,2.

7. Appareil selon la revendication 1, dans lequel le composé de scintillation répond à la formule suivante :
M1³⁺_{(8-8x-8y)}RE⁴⁺₈ₓM2²⁺_{8y}O₁₂
dans laquelle :
M1³⁺ est un élément métallique trivalent, qui peut inclure ou non un métal des terres rares trivalent ;
M2²⁺ est un élément métallique divalent ;
RE⁴⁺ est un métal des terres rares tétravalent ;
x est supérieur à 0 et inférieur ou égal à 0,2, y est supérieur ou égal à 0 et inférieur ou égal à 0,2 ; et
(x+y) est supérieur ou égal à 0,0001 et inférieur à 0,2.

8. Appareil selon la revendication 1, dans lequel le composé de scintillation répond à la formule suivante :
M1²⁺_{(2-2x-2y)}RE1³⁺ₓM2¹⁺_{y}M3²⁺_{(10-10a-10b)}RE2⁴⁺₁₀ₐₓM4²⁺_{10b}O₁₇
dans laquelle :
chacun de M1²⁺ et M4^{2x} est un élément métallique divalent ;
M2¹⁺ est un élément métallique monovalent ;
M3^{3x} est un élément métallique trivalent qui peut inclure ou non un métal des terres rares trivalent ;
RE1³⁺ est un métal des terres rares trivalent ;
RE2⁴⁺ est un métal des terres rares tétravalent ;
a et x sont supérieurs à 0 et inférieurs ou égaux à 0,2, et chacun de b et y est supérieur ou égal à 0 et inférieur ou égal à 0,2 ; et
(x+y) et (a+b) sont tous deux supérieurs ou égaux à 0,0001 et inférieurs à 0,2.

9. Appareil comprenant un scintillateur incluant un composé de scintillation comprenant un métal des terres rares dans un état tétravalent à une concentration atomique d'au moins 10 ppm du composé de scintillation, dans lequel le composé de scintillation n'est pas un composé silicate de terres rares, dans lequel le composé de scintillation est un composé métal-bore-oxygène.

10. Appareil selon l'une quelconque des revendications précédentes, l'appareil étant un appareil de détection de rayonnement et comprenant en outre un photocapteur configuré pour recevoir une lumière scintillante provenant du scintillateur.

11. Appareil selon l'une quelconque des revendications précédentes, l'appareil comprenant un appareil d'imagerie médicale, un appareil de diagraphie de puits ou un appareil d'inspection de sécurité.

12. Appareil selon l'une quelconque des revendications précédentes, l'appareil étant un dispositif laser ou un dispositif de stockage de données optique.

13. Appareil selon l'une quelconque des revendications précédentes, dans lequel le métal des terres rares à l'état tétravalent est à une concentration atomique inférieure ou égale à 5 % du composé de scintillation.

14. Appareil selon l'une quelconque des revendications précédentes, dans lequel le métal des terres rares est un métal des terres rares particulier à l'état tétravalent, dans lequel le métal des terres rares particulier à l'état tétravalent représente au moins 5 % et 90 % ou moins de la teneur totale du métal des terres rares particulier dans le composé de scintillation.
